# EUROPEAN PATENT APPLICATION

(11) **EP 4 454 492 A1**
(43) Date of publication of application: **30.10.2024**
(21) Application number: 23169787.1
(22) Date of filing: 25.04.2023
(51) Int. Cl.: A24D 1/20, A24F 40/46, H05K 1/03, H05K 1/11

(54) **HEATED TOBACCO SYSTEM, DEVICE AND CONSUMABLE**

(71) Applicant: IMPERIAL TOBACCO LIMITED, Bristol BS3 2LL (GB)
(72) Inventor: The designation of the inventor has not yet been filed
(74) Representative: Mewburn Ellis LLP

(57) **Abstract**

A heated tobacco (HT) consumable (100) comprises an electrically conductive track 180, which may be a heating element, arranged between an aerosol-generating substrate (110) and a combining paper (120) that wraps around the aerosol-generating substrate. Electrical contacts 181, 182 of the electrically conductive track are exposed through the combining paper. Each electrical contact may be a contact band around the consumable. A disc (132, 135) may be provided to close one or both ends of the aerosol-generating substrate. The consumable may be configured to be inserted into the cavity of a heated tobacco device (200) in an upstream to downstream direction.

## Description

### TECHNICAL FIELD

The present invention relates to a smoking substitute system and particularly, although not exclusively, to a smoking substitute system comprising a device and an aerosol-forming article. More particularly, a heated tobacco system comprising an electronic device and an insertable consumable, wherein the consumable is heated to generate an inhalable aerosol.

### BACKGROUND

Smoking substitute systems include electronic aerosol generation systems that permit a user to simulate the act of smoking by producing an aerosol (also referred to as a "vapour") that is drawn into the lungs through the mouth (inhaled) and then exhaled.

One technology platform for a smoking substitute system is a class of products that use the "heated tobacco" ("HT") approach in which tobacco is heated or warmed to release vapour. In the HT approach the tobacco is heated but not burned, i.e. the tobacco does not undergo combustion. The HT approach recognises that burning tobacco is not necessary to release constituents from the tobacco leaf. Rather, release is achieved at temperatures of around 350°C or less. Because HT systems do not combust the tobacco, the lower temperatures of HT systems are expected to expose the user to emissions that have fewer chemicals and / or in smaller amounts than the smoke from a combustible cigarette. HT systems are well known in the industry. And although referred herein as HT systems, they may also be known as heated tobacco products (HTP), Heat not Burn (HNB) and smokeless systems.

The HT class of products are easily distinguishable over e-cigarettes (or vapes), which are an alternative class of smoking substitute system based on a technology platform that uses a device to heat a pod or cartridge filled with a liquid (also termed e-liquid). Here, a primary difference is that HT systems produce an aerosol from tobacco leaf, whereas in e-cigarettes, the aerosol is provided from a liquid suspension.

A typical HT system includes a HT device and a HT consumable comprising the tobacco, which is replaced at the end of a smoking session. It will be appreciated that the HT system can, herein, be interchangeably referred to as a 'system' and likewise, the HT device can be interchangeably referred to as a device, and also the HT consumable can be interchangeably referred to as a consumable. At a basic level, the consumable is inserted into the device to form a system, such that the user can operate the system to heat the consumable in a controlled manner to release flavours, aromas and other constituents whilst volatising the nicotine in the tobacco (without burning). A user can then draw on a mouthpiece of the system to draw air through the tobacco. The released constituents and volatised nicotine is entrained in the airflow to create an aerosol as it mixes and cools. The aerosol is then inhaled by the user. A known HT device is sold under the brand name Pulze ^{™} for use in combination with a HT consumable sold under the brand name iD ^{™}.

Known HT consumables comprise three portions positioned sequentially end-to-end to form a rod, including but not limited to: a tobacco portion, a cooling portion, and a mouthpiece (or mouthpiece filter). Here, the tobacco portion forms an upstream end portion of the consumable and the mouthpiece filter the downstream end portion of the consumable. In The iD ^{™} stick, the cooling portion comprises a bore filter and a paper tube positioned sequentially such that the rod comprises: a tobacco portion, a bore filter, a paper tube, and a mouthpiece filter positioned sequentially from the upstream end to the downstream end and end-to-end to form the rod. In such consumables, the rod is held together by a combination of a combining paper and a tipping paper which overlap (i.e. an overlap region). In the iD ^{™} stick, the overlap region is adjacent the paper tube. In other words, the combining paper circumscribes (where circumscribes includes a substantially single wrap as well as any gluing overlap) the tobacco portion, the hollow bore filter and part of the paper tube, and the tipping paper circumscribes the mouth filter and part of the paper tube such that a region of the tipping paper circumscribes a region of the combining paper. There may consequently be an increased diameter along the overlap region, with respect to the rest of the rod. For instance, the diameter of a consumable changes from the upstream end to the downstream end by 0.08 mm (twice the thickness of the tipping paper).

It will be appreciated that as a diameter of the consumable increases, the packing density of such consumables decreases. Those skilled in the art will recognise that a lower packing density will increase costs, e.g. of transportation, due to an increased packing volume for a typical pack of consumables. Furthermore, variability in diameter along the rod can affect the alignment of consumables when packed together e.g. in a typical pack of consumables and whilst moving through the manufacturing environment (for instance because the consumable can be presented at a slight angle rather than an assumed true axial alignment). Those skilled in the art will recognise that misalignment of consumables can increase issues during manufacturing and diminish the aesthetic appeal of packaged consumables (i.e. the consumables don't look neatly packed).

HT consumables are typically manufactured, packaged, and prepared for transportation on a single production line processing thousands of consumables a minute. Typical production lines comprise a plurality of machines and stations including but not limited to a strip cut maker, a plurality of buffers (e.g. one for each of the tobacco portion, the bore filter, the paper tube, and the mouthpiece filter), a combiner, a packer, and a transportation case filler. Further buffers can be provided between the stations as is required.

When the tobacco portion is formed from reconstituted tobacco leaf, the reconstituted tobacco leaf is first formed into a rod at a strip cut maker. Here, a reel of reconstituted tobacco may be fed into the production line. New reels may be spliced to nearly depleted reels to provide a continuous stream of reconstituted tobacco. The reconstituted tobacco is subsequently cut into a plurality of strips that resemble continuous lengths of spaghetti and a plurality of the strips are then formed into a rod. Optionally, a flavourant such as menthol may be applied to the tobacco material at this stage. The stirp cut maker typically circumscribes the rod of tobacco with a wrapping paper or optionally a lacquered foil-paper laminate. Circumscribing the tobacco with a metal foil, prevents misuse of the HT consumable through use of the HT consumable as a combustible cigarette (i.e. because the metal foil prevents or inhibits or supresses ignition). The plurality of strips formed into a cylindrical rod are then cut to length for use in the combiner. As explained below, in order to achieve the fast-processing times, each cylindrical rod of tobacco is cut to form a double length tobacco portion. In other words, the tobacco material is formed into rods sufficiently long so as to form two consumables when cut in half. The double tobacco portion is then transferred to a buffer for storage, whereat the plurality of double tobacco portions may be closely packed.

Likewise, double lengths of each component of the cooling portion and the mouthpiece filter are stored in respective buffers in a closely packed formation. For example, in some arrangements, double lengths of each of the tobacco portion, the bore filter, the paper tube and the mouthpiece filter are stored in buffers for supplying the combiner.

Double lengths of each component are supplied to the combiner when required. Within the combiner, the double length paper tube may be cut in half to form a single length paper tube. The double length bore filter may subsequently be sandwiched between each single length paper tube to form a first unit. The first unit may subsequently be cut in half (through the centre of the double length bore filter) to form two second units (each comprising a single length bore filter abutting a single length paper tube). The double length tobacco portion is subsequently sandwiched between each second unit to form a third unit.

A double width (where here the width is formed along the length or longitudinal axis of the consumable) of combining paper may then be fed into the combiner. Similar to the reel of reconstituted tobacco, the reel of combining paper may be unwound with new reels spliced to nearly depleted reels via a splicing unit to give a continuous stream of combining paper. Within the combiner, adhesive may be applied to the combining paper. Subsequently, the combining paper with adhesive may be wrapped around the third unit. The adhesive may be consolidated before the wrapped third unit is cut into two fourth units (through the centre of the double length tobacco portion). That is, the cut forms the distal, upstream end of the HT consumable, and because the cut is made through the combining paper and tobacco portion, the distal end has a planar face that is flush with the tobacco and combining paper. At this stage, each fourth unit may comprise a tobacco portion abutting a bore filter, itself abutting a paper tube circumscribed by combining paper. Due to the width of the combining paper being lesser than the length of the fourth unit, the combining paper may circumscribe the third unit such that an end of the combining paper may be flush with a tobacco portion end and such that the paper tube may protrude from an opposing end of the combining paper. Each fourth unit is then inverted such that the paper tubes are adjacent to one another, and the tobacco portions are facing outward. Subsequently, a double length mouthpiece filter is sandwiched between the fourth units to form a fifth unit.

A double width tipping paper is then fed into the combiner. Similar to the reel of combining paper, the reel of tipping paper may be unwound with new reels spliced to nearly depleted reels to give a continuous stream of tipping paper. Within the combiner, adhesive is applied to the tipping paper. Subsequently, the tipping paper with adhesive is wrapped around the centre of the fifth unit. The tipping paper has a width such that overlap regions are formed where the tipping paper circumscribes the paper tube and the combining paper. The adhesive is then consolidated before the fifth unit is cut in half (through the centre of the double length mouthpiece filter) to form two consumables. A laser is then typically used to perforate the tipping paper and the paper tube proximal to the mouthpiece end of each consumable to complete the combining process. Here, the perforations are distributed radially and circumferentially to provide ventilation downstream of the tobacco material for the introduction of ventilation air.

The consumables are subsequently transferred to a packer, whereat the individual consumables are packaged into a pack of consumables. Here, firstly, a plurality of consumables (perhaps twenty) are arranged into an array having a standard number of rows and columns, before the array of consumables are placed in the packaging (e.g. a plastic wrapping and cardboard presentation box). Due to the combiner and packer processing the same number of consumables per minute, noticeably, the number of packages exiting the packer per minute are greatly reduced compared to the number of consumables exiting the combiner per minute (necessarily by a factor of twenty based on the number of consumables in the pack). Each pack is then wrapped e.g. in cellophane and a plurality of packs packaged together by a transportation case filler.

The skilled person would recognise that this manufacturing process may require the close packing of several units and consumables as well as relying on a true orientation of the consumable's longitudinal axis. Consequently, it is important to maintain a constant and consistent external diameter of the consumable, as variations can have detrimental impact on the packing formation, resulting in a lower packing density and a higher packing volume of the consumables and intermediary units, as well as reduced conformity and alignment in the packaging impacting the visual presentation of the packaged consumables to the end user. Moreover, variations in diameter may cause misalignment of consumables within the plurality of machines during the manufacturing process. This may result in inconsistent manufacturing of the consumables.

As described above, in existing consumables, the rod comprises an upstream tobacco end and an opposing, downstream mouthpiece end. The mouthpiece end (also the mouthpiece or mouth end) is defined by an end surface of the mouthpiece filter and the tobacco end is defined by an end surface of the tobacco portion. Moreover, the mouthpiece end is flush with an end of the tipping paper and the tobacco end is flush with an end of the combining paper. Tobacco material is therefore exposed at the end of the consumable. Those skilled in the art will recognise that tobacco material is therefore prone to falling or being pulled out of the consumable in use (e.g. into a cavity of the device used to heat the consumable). If the device is not cleaned, this tobacco material may stick to the heater and increase odour or decreased performance. The tobacco material left in the cavity is also undesirable from a user point of view due to the tobacco particles then contaminating a user's pocket or bag or the like in which the HT device is typically carried. Furthermore, during the manufacturing process, particles or fibres of the tobacco falling out of the consumable can contaminate the machines and eventually require maintenance or cleaning downtime.

Known HT devices comprise a cavity for receiving the HT consumable, where a heater is arranged in or about the cavity. The device therefore further comprises a power source (e.g. a battery) and control electronics for connecting the power source and heater, suitably via a user interface. Of course, the device also typically includes a charging port and the control electronics, as well as controlling the discharge of the power source to the heater (i.e. to activate the heater), also controls the recharging of the power source.

In the Pulze ^{™} device, a housing is provided to define the cavity and to house the power source, control electronics and user interface (i.e. power button). The housing has a generally longitudinal shape, having a longitudinal axis that is aligned with the cavity such that when the consumable is inserted, the consumable and device have a common axis. Here, the housing has an electronics compartment at an upstream end of the device with the cavity at the downstream end. That is, the consumable is inserted into the cavity in a downstream to upstream direction. A charging connector is provided at the upstream end of the housing and a power button is provided on a side face. The housing defines an airflow passage to the upstream end of the cavity (i.e. the bottom of the closed cavity). In the Pulze ^{™} device, the airflow is provided to the bottom of the cavity through a gap formed between the housing and a liftable cap that includes the cavity.

To use the HT system, the device and consumable are physically coupled together by inserting a consumable into the cavity, with the upstream tobacco portion inserted first. Once the consumable is fully inserted into the cavity, the mouthpiece filter protrudes from the cavity of the device and the tobacco portion end abuts a closed end of the cavity.

The user can then activate the HT device via the user interface's power button as is known. Activating the HT device turns on the heater and starts a predetermined smoking session (e.g. period of heater on time). In use, heat is imparted to the tobacco material by the heating element of the device, wherein airflow through the tobacco material causes moisture in the tobacco material to be released as vapour.

The airflow through the tobacco is provided through the device by the airflow passage to the closed bottom end of the cavity. The airflow then passes along the consumable, entraining vapour formed by the tobacco material and any flavourant, in addition to volatile compounds released from the tobacco as it passes through the tobacco portion. The airflow then continues through the cooling section, entraining cool airflow entering the consumable through the perforations in the tipping paper and paper tube. The cooled airflow may finally continue through the mouthpiece filter, which acts to cool the vapour to a comfortable temperature to be inhaled, and out of the consumable through the mouthpiece filter at the downstream end of the consumable and therefore system.

Various heaters are known for HT systems. The Pulze ^{™} device utilises a resistive heating rod as the heating element wherein resistive heating wires are arranged on the heating rod and the wires generate heat when supplied with power from the power source. The resistive heating wires transfer the heat by conduction to the tobacco which is in close proximity or in contact to the heating wires. Here, the heating rod is arranged coaxially in the cavity and insertion of the consumable into the cavity causes the heating rod to penetrate into the tobacco such that the heating rod heats the tobacco from the inside out. Flat blades have also been used for inside out heating. During use, the penetration of the heater into the tobacco portion exerts forces on the tobacco, which may cause the tobacco portion to be undesirably moved or shifted by the relative motion between the heating element and the consumable. Moreover, this penetration may disturb the tobacco material such that the tobacco material falls into the cavity of the device upon removal of the consumable from the device. For instance, the tobacco can be pulled out of the consumable as the heater element is withdrawn.

For the reasons stated above, there is a need for an improved design of HT system to enhance the user experience and to improve the manufacturing and transporting of such consumables and any method thereto. Aspects and embodiments have been devised with the foregoing in mind.

### SUMMARY OF THE INVENTION

At its most general, another aspect of the present invention provides a Heated Tobacco (HT) consumable wherein an electronic component is arranged between a combining paper that wraps around an aerosol-generating substrate, wherein electrical contacts on the electronic component are exposed through the combining paper.

In the exemplary HT consumable aspects and embodiments described and claimed herein, the HT consumable comprises an aerosol-generation substrate. As explained above, the aerosol-generation substrate is a solid (as opposed to liquid) substrate capable of being heated to release at least one volatile compound that can form an aerosol. It will be appreciated that tobacco leaf is one such substrate, wherein an aerosol is generated by inhaling through the heated substrate. However, those skilled in the art will be aware that HT systems might also be easily configured to heat non-tobacco organic material such as other plant material (e.g., cannabis leaf). Consequently, a heated tobacco consumable is intended at its broadest to include an aerosol-generating substrate comprising at least one volatile compound that is intended to be vaporised/aerosolised and that may provide the user with a recreational and/or medicinal effect when inhaled. Suitable chemical and/or physiologically active volatile compounds include the group consisting of: nicotine, cocaine, caffeine, THC, CBD, opiates and opoids, cathine and cathinone, cannaboids, kavalactones, mysticin, beta-carboline alkaloids, salvinorin A, together with any combinations, functional equivalents to, and/or synthetic alternatives of the foregoing.

Consequently, in the exemplary HT consumable aspects and embodiments described and claimed herein, the aerosol-generation substrate of the HT consumable suitably comprises a plant material. The plant material may comprise least one plant material selected from the list including Amaranthus dubius, Arctostaphylos uva-ursi (Bearberry), Argemone mexicana, Amica, Artemisia vulgaris, Yellow Tees, Galea zacatechichi, Canavalia maritima (Baybean), Cecropia mexicana (Guamura), Cestrum noctumum, Cynoglossum virginianum (wild comfrey), Cytisus scoparius, Damiana, Entada rheedii, Eschscholzia califomica (California Poppy), Fittonia albivenis, Hippobroma longiflora, Humulus japonica (Japanese Hops), Humulus lupulus (Hops), Lactuca virosa (Lettuce Opium), Laggera alata, Leonotis leonurus, Leonurus cardiaca (Motherwort), Leonurus sibiricus (Honeyweed), Lobelia cardinalis, Lobelia inflata (Indian-tobacco), Lobelia siphilitica, Nepeta cataria (Catnip), Nicotiana species (Tobacco), Nymphaea alba (White Lily), Nymphaea caerulea (Blue Lily), Opium poppy, Passiflora incamata (Passionflower), Pedicularis densiflora (Indian Warrior), Pedicularis groenlandica (Elephant's Head), Salvia divinorum, Salvia dorrii (Tobacco Sage), Salvia species (Sage), Scutellaria galericulata, Scutellaria lateriflora, Scutellaria nana, Scutellaria species (Skullcap), Sida acuta (Wireweed), Sida rhombifolia, Silene capensis, Syzygium aromaticum (Clove), Tagetes lucida (Mexican Tarragon), Tarchonanthus camphoratus, Tumera diffusa (Damiana), Verbascum (Mullein), Zamia latifolia (Maconha Brava) together with any combinations, functional equivalents to, and/or synthetic alternatives of the foregoing.

It will however be appreciated that in particularly suitable exemplary embodiments, the plant material is tobacco. Here, in the exemplary HT consumable aspects and embodiments described and claimed herein, any type of tobacco may be used. This includes, but is not limited to, flue-cured tobacco, burley tobacco, Maryland Tobacco, dark-air cured tobacco, oriental tobacco, dark-fired tobacco, perique tobacco and rustica tobacco. This also includes blends of the above-mentioned tobaccos.

The tobacco may comprise one or more of leaf tobacco, stem tobacco, tobacco powder, tobacco dust, tobacco derivatives, expanded tobacco, homogenised tobacco, shredded tobacco, extruded tobacco, cut rag tobacco and/or reconstituted tobacco (e.g., slurry recon or paper recon). In each case, the aerosol-generating substrate is formed into a rod of material. For instance, as termed herein, a tobacco rod. The aerosol-generating substrate (i.e., tobacco rod) is suitably formed into a substantially cylindrical shape such that the article/consumable resembles a conventional cigarette. The aerosol-generating substrate may have a diameter of between 5 and 10mm (e.g., between 6 and 9mm or 6 and 8mm e.g., around 7 mm). The aerosol-generating substrate may have an axial length of between 10 and 25mm (e.g., between 11 and 14mm such as around 12 or 13mm).

In exemplary embodiments comprising recon tobacco, the aerosol-generation substrate may comprise a gathered sheet of homogenised recon tobacco or gathered shreds/strips formed from such a sheet.

Here, the plurality of strips may be substantially aligned. Moreover, the plurality of strips, parallel to one another, may be substantially parallel to a longitudinal axis of the rod. In addition to this, the plurality of strips may be tightly packed together. The skilled person will recognise that the plurality of strips of reconstituted tobacco are prone to fracture and that the tobacco material is therefore likely to fall out of the consumables during, and particularly after, use. Therefore, whilst recon tobacco provides greater resistance to being pulled out of the consumable and therefore the problems associated with tobacco falling out of the consumable still exists and moreover the risk is increased when using other types such as cut rag tobacco. Consequently, the closed end HT consumable aspects and embodiments are beneficial to consumables including recon tobacco as the aerosol-generating substrate and may be particularly beneficial to HT consumables formed with an aerosol-generation substrate comprising non-recon tobacco.

In exemplary aspects and embodiments described and claimed herein, the aerosol-generating substrate may comprise one or more additives selected from humectants, flavourants, fillers, aqueous/non-aqueous solvents and binders. Here, the flavourant may be provided in solid or liquid form. It may include menthol, liquorice, chocolate, fruit flavour (including e.g., citrus, cherry etc.), vanilla, spice (e.g., ginger, cinnamon) and tobacco flavour. The flavourant may be evenly dispersed throughout the aerosol-generating substrate or may be provided in isolated locations and/or varying concentrations throughout the aerosol-generating substrate.

All the exemplary aspects and embodiments described and claimed herein comprise the HT consumable being specifically adapted for use with a HT device (either known devices or the HT devices described and claimed herein). In particular, a combustible cigarette is not specifically adapted for use with a HT device. Primarily, this is because insertion of a combustible cigarette into a HT device and subsequent operation of the HT device, would not generate an acceptable vapour for consumption by the user. In particular, an insufficient aerosol vapour would be generated. Consequently, in the exemplary embodiments of HT consumables described and claimed herein, one specific adaption for use with a HT device is the incorporation of a carrier in the tobacco material. Here, during use, a first vapour is produced from the tobacco material volatising the nicotine (or other active substance as described above) and a second vapour is produced from vaporisation of the carrier. Any known or suitable carrier is considered. For instance, the carrier added to the aerosol-generating substrate (e.g., the plant material such as tobacco) suitably comprises polyglcol (PG), propylene glycol, and/or vegetable glycerine (VG).

In the exemplary HT consumable aspects embodiments described and claimed herein, in addition to an aerosol-generating substrate, there may also be provided further components or elements combined with the aerosol-generating substrate as is known in the art as well as described and claimed herein. Thus, the exemplary HT consumables may include an aerosol-generating substrate combined with one or more further components or elements by a combining paper. Here, the combining paper circumscribes the aerosol-generating substrate and further components and is glued or adhered to form a homogenous component or rod as is known in the art and as explained in the background section above. Therefore, except where incompatible, the addition or combination of features of the described and claimed aspects and embodiments of the consumables is expressly considered. Furthermore, as used herein, combining paper in its broadest is intended to include any suitable substrate that can be used to circumscribe the components of the consumable to join or wrap one or more of the components. It is envisaged that suitable substrates are thin and flexible, with paper or similar materials being exemplary. Thus, as used herein, wrapping substrate is used interchangeably to reference combining paper in its broadest form even for instance when the combining paper is not combining components.

As will become apparent, the described or claimed aspects and embodiments are suitable for use with a HT system wherein the HT consumable is intended to be used as described in the background section above. That is, with the consumable inserted into a cavity at a downstream end of the HT device. Or stated alternatively, wherein the consumable is insertable into the cavity in a downstream to upstream direction. Herein, such arrangements can be termed 'downstream' consumable. Here, the aerosol-generating substrate is arranged at an upstream end and a distal, downstream end of the HT consumable comprises a mouthpiece. For instance, a mouthpiece filter (e.g., a terminal filter arrangement). Here, suitably, the mouthpiece filter may comprise a monoacetate filter or a hollow bore filter. In some arrangements, the hollow bore filter may be a triple bore filter e.g., with three bores arranged in an equilateral triangle around a central axis. Alternatively, the mouthpiece filter may be comprised of cellulose acetate or polypropylene tow. Further alternatively, the mouthpiece filter element (e.g., the terminal filter element) may be comprised of activated charcoal or may be comprised of paper. In each case, the mouthpiece filter element is suitably at least partly (e.g., preferably, but not necessarily entirely) circumscribed with a plug wrap e.g., a paper plug wrap. In some arrangements of the downstream HT consumables, the mouthpiece filter may include flavourant. For instance, the mouthpiece filter can be formed with a capsule able to be fractured (fractureable) that a user can fracture to release a vapour or liquid (e.g., provided with a crush ball) as is known in the art.

In the exemplary downstream HT consumables, the mouthpiece filter (at the downstream end of the consumable) is suitably joined to the upstream elements forming the consumable and including at least the aerosol-generating substrate by a circumscribing tipping layer e.g., a tipping paper layer. The tipping paper may have an axial length longer than the axial length of the terminal filter element such that the tipping paper completely circumscribes the terminal filter element plus the wrapping layer surrounding any adjacent upstream element.

As explained, the HT consumables of the aspects and embodiments described and claimed may comprise further components and elements. For instance, in exemplary downstream HT consumables further elements can be arranged between the aerosol-generating substrate and the mouthpiece filter.

Whereas in non-downstream embodiments which might not necessarily comprise a mouthpiece filter, the further elements may be provided to either or one side of the aerosol-generating substrate. For instance,

in some embodiments, the consumable comprises an aerosol-cooling element which is adapted to cool the aerosol generated from the aerosol-generating substrate (by heat exchange) before being inhaled by the user. That is, in such consumables, the cooling element regulates the temperature of vapour. In some exemplary arrangements, wherein the cooling element may suitably comprises a bore filter and a paper tube, each of the bore filter and the paper tube regulate the temperature of the vapour in use. In some arrangements, the bore filter may be a hollow bore filter. In some arrangements, the paper tube may be a spiral paper tube. In other words, the paper tube may be a continuous paper tube wound in a spiral or the paper tube may be a cardboard tube. In the exemplary embodiments, the paper tube itself may be impermeable to air but comprise a plurality of perforations e.g., formed by a laser. The plurality of perforations may be distributed circumferentially about the paper tube and correspond in number and location with the plurality of perforations of the tipping paper to provide ventilation into an internal cavity of the paper tube.

At its most general, one aspect of the present invention provides a Heated Tobacco (HT) consumable having a closed end. By closing the end so that the tobacco portion is not exposed to a distal end, advantageously, a consumable is provided that reduces the risk or likelihood of tobacco from falling out or being pulled out from the consumable in use or during transportation and / or during the production process.

According to one exemplary aspect, a closed end consumable is manufactured by initially forming a recess at a distal end of the part-processed consumable. In other words, the distal end of the part-processed consumable has a distal end formed by a plane of a hollow portion of wrapping substrate, with the end face of the aerosol-generating substrate (i.e., the tobacco) recessed back from the plane including the distal end of the wrapping substrate. Advantageously, the recessed distal end of the part-processed HT consumable enables further processing steps to close the end face of the aerosol-generating substrate. That is, to cover the aerosol-generating substate such that the aerosol-generating substrate is not exposed through the distal end of the consumable, as is the case with the known forming processes. As will be understood, where the wrapping substrate wraps around two components (i.e., the aerosol-generating substrate and a further component such as a hollow tube or the like), the wrapping substrate may be termed combining paper. Whilst combining paper is used herein, except where necessary, use of the term combining paper does not have an implicit requirement for the wrapping substrate to combine further components. In the exemplary aspect, the recess is formed by arranging a first single-length aerosol-generating substrate on a combining paper and a second single-length aerosol-generating substrate on the combining paper. The combining paper is simultaneously wrapped around the first and second single-length aerosol-generating substrates to generate a unit wherein the combining paper circumscribes the first and second single-length aerosol-generating substrates and also circumscribes a double length recess formed between the respective aerosol-generating substrates. Cutting through the combining paper, and preferably along the centre of the recess between the respective aerosol-generating substrates creates two part-processed consumables, with each part-processed consumable having a recess on a distal end.

There is therefore provided a method of manufacturing a HT consumable, the method comprising providing a width of combining paper and arranging a first aerosol-generating substrate and a second aerosol-generating substrate on the combining paper, wherein the respective aerosol-generating substrates are spaced apart. Because the first and second aerosol-generating substrates are separate components, by spacing them apart, a space or gap is created between the respective substrates. The method comprises the step of wrapping the combining paper around the aerosol generating substrates and gap therebetween. The method subsequently comprises cutting the combining paper through the portion of the combining paper surrounding the gap to form two part-processed HT consumables, wherein each part-processed HT consumable includes a recessed distal end. That is, each part-processed HT consumable comprises a distal end portion including an end face of the aerosol-generating substrate and an overhanging length of combining paper. For instance, in the envisaged exemplary embodiments, the aerosol-generating substrate is a rod and the overhanging combining paper is therefore a hollow cylinder that extends from the end face of the aerosol-generating substrate. Advantageously, the method therefore provides an improved manufacturing process for forming a recessed distal end that can be readily employed with minimal adaption of existing processing machines. For instance, existing combiners can be readily adapted to place separate first and second aerosol-generating substrates on combining paper.

In the exemplary embodiments, each aerosol-generating substrate is a single-length. That is, the length of the aerosol-generating substrate is intended to be a length suitable to form a single HT consumable.

Moreover, the step of placing the first and second aerosol-generating substrates places the respective substates in axial alignment. That is, each aerosol-generating substrate has a longitudinal axis, and when placed on the combining paper, the longitudinal axes are aligned and coincident. Suitably, the first aerosol-generating substrate may be a cylindrical rod. Here, the cylindrical rod has opposed end faces.

Each end face is a planar face. That is, the end face is said to be a planar face along the predominant plane of the aerosol-generating substrate, even though the end face may be formed from the termination of multiple strands at the common plane. So, in the example of a tobacco rod, the tobacco rod has a planar face on each end, even though the end face may be formed from the termination of multiple strands of tobacco with voids therebetween. The cylindrical rod has a longitudinal axis, and the end faces are suitably perpendicular to the longitudinal axis. Moreover, suitably the second aerosol-generating substrate is the same type of element as the first aerosol-generating substrate. That is, the first and second aerosol-generating substrates, whilst distinct and separate components, may be otherwise substantially identical. It is understood here, that identical includes variations due to any randomness on the aerosol-generating substrate.

In the exemplary embodiments, the step of wrapping the combining paper around the first aerosol-generating substrate, the second aerosol-generating substrate and the gap comprises cutting the combining paper and gluing or adhering the combining paper as is known in the art. Suitably, the step of cutting the combining paper through the portion comprising the gap, comprises cutting through the centre of the gap so that the two part-processed HT consumables are formed with the same sized overhang of combining paper. As will be appreciated, the cut is suitably made perpendicularly to a longitudinal axis of the combining paper.

The length of the gap or space between the first and second aerosol-generating substrates is predetermined. In some exemplary aspects, the space is relatively large, for instance equal or greater than a diameter of the aerosol-generating substrates. That is, when cut in half, a length of the overhang is equal to or greater than a radius of the aerosol-generating substrate. Thus, where the diameter of the aerosol-generating substate is suitably between 5-1 0mm, the gap between the first and second aerosol-generating substrates is correspondingly equal or greater than 5-1 0mm. Here, the method suitably further comprises folding the combining paper to close the distal end portion of the HT consumable. In alternative exemplary aspects, the space is relatively small, for instance less than the diameter of the aerosol-generating substrates. That is, when cut in half, a length of the overhang is less than a radius of the aerosol-generating substrate. Thus, where the diameter of the aerosol-generating substate is suitably between 5-1 0mm, the gap between the first and second aerosol-generating substrates is correspondingly less than 5-10mm. Here, the method suitably further comprises inserting a membrane into the recess to close the distal end portion of the HT consumable.

At its most general, the present invention provides a Heated Tobacco (HT) consumable having a closed end. By closing the end so that the tobacco portion is not exposed to a distal end, advantageously, a consumable is provided that reduces the risk or likelihood of tobacco from falling out or being pulled out from the consumable in use or during transportation and / or during the production process.

In a further exemplary aspect, there is therefore provided a method of manufacturing a HT consumable, the method comprising providing a width of wrapping substrate and arranging a first aerosol-generating substrate and a second aerosol-generating substrate on the wrapping substrate, wherein the respective aerosol-generating substrates are spaced apart. The method comprises the step of wrapping the wrapping substrate around the aerosol generating substrates and a gap therebetween. The method subsequently comprises cutting the combining paper through the portion of the wrapping substrate surrounding the gap to form two part-processed HT consumables, wherein each part-processed HT consumable includes a recessed distal end. That is, the method comprises the exemplary aspect as described above and herein. In this aspect however, the method further comprises, subsequent to creating the recessed distal end, folding the wrapping substrate to close or cover the end face of the aerosol-generating substrate. Advantageously, there is therefore provided an improved method of forming an HT consumable. As will be understood, where the wrapping substrate wraps around two components (i.e., the aerosol-generating substrate and a further component such as a hollow tube or the like), the wrapping substrate may be termed combining paper. Whilst combining paper is used herein, except where necessary, use of the term combining paper does not have an implicit requirement for the wrapping substrate to combine further components.

In the exemplary embodiments, the combining paper folded over the end face is perforated. As used herein, perforated includes mechanically puncturing the substrate, for instance by laser drilling or ablations (i.e. micro drilling small holes) as well as substrates that are porous (i.e., that has a porosity that allows air to be drawn through the substrate). There is therefore further provided a HT consumable comprising a combining paper circumscribing an aerosol-generating substrate, wherein a continuous portion of the combining paper is perforated and folded over an end face of the aerosol-generating substrate. Advantageously, the HT consumable has a closed end that provides a reduced risk of particles or fibres of the aerosol-generating substrate from falling or being pulled from the consumable, whilst maintaining airflow through the end of the consumable to communicate with the aerosol-generating substrate. Moreover, by being formed from a continuous portion of the combining paper, the external dimension of the consumable is not affected. The HT consumable may suitably be formed using the exemplary methods as explained above and herein.

Suitably, the exemplary methods comprise perforating the combining paper prior to cutting through the combining paper at the region of the gap. Here, the combining paper may be pre-perforated prior to providing the combining paper. Alternatively, the combining paper can be perforated once wrapped around the respective aerosol-generating substrates. In either case, the perforations are formed to allow airflow through the closed distal end. That is, the perforations are formed on the portion of the combining paper that is folded over the distal end. Here, as will be understood, the perforations are formed in the portion of the combining paper that circumscribes the gap between the first and second aerosol-generating substrates.

The perforations are suitably formed using laser ablation techniques. For instance, laser ablation is described in the background section as being used to create perforations in the tipping paper, and the same process and techniques can be readily adapted to perforate the combining paper. Thus, the exemplary HT consumable may include perforations comprising a plurality of holes. The holes are sized so as to allow air flow through the combining paper but to prevent movement of the aerosol-generating substrate or particles thereof from passing.

In some exemplary embodiments, the recessed end of the part-processed consumable is formed from a generally cylindrical portion of the combining paper overhanging from the end of the aerosol-generating substrate. In one embodiment, the cylinder is crushed to randomly fold the overhanging combining paper over an end face of the aerosol-generating substrate. Alternatively, some exemplary methods comprise folding the overhanging combining paper by creasing the combining paper to form a predetermined fold shape. For instance, a letter box fold. Again, the combining paper can be scored prior to being provided wherein the score lines correspond to the intended creases once the combining paper is wrapped and cut. Additionally, or alternatively, the combining paper may be provided with cuts and / or removed segments at the portion of the combining paper that wraps around the gap or space between the two aerosol-generating substrates. Here, the combining paper remains a unitary piece until it is cut through the gap. Once cut, the cuts or removed segments provide a shaped profile to assist in the folding. For instance, once cut, the overhanging portion of the combining paper form a plurality of fingers. Here, the method comprises folding each finger to cover a portion of the aerosol-generating substrate's end face. Suitably, the fingers can be folded sequentially in an iris pattern to substantially cover the end face of the aerosol-generating substrate.

As mentioned, the combining paper can be pre-formed with cuts and removed portions to provide a predetermined fold shape. Whilst in some embodiments, for instance, when the consumable is intended to be used with a HT device where the heater is not required to penetrate the aerosol-generating substrate, the method and HT consumable may be configured so that the folded combining paper substantially covers the entire end face of the aerosol-generating substrate, in instances where it is intended the consumable be used with a device that does penetrate the aerosol generating substrate, the combining paper can be folded to maintain an open portion corresponding to a size to accommodate the penetrating heater. That is, the combining paper of the part-processed consumable having a recessed end is configured through cuts or removed segments of the combining paper, such that when folded an aperture is formed. The formed aperture exposes a portion of the end face of the aerosol-generating substrate.

At its most general, the present invention provides a Heated Tobacco (HT) consumable having a closed end. By closing the end so that the tobacco portion is not exposed to a distal end, advantageously, a consumable is provided that reduces the risk or likelihood of tobacco from falling out or being pulled out from the consumable in use or during transportation and / or during the production process.

In a further exemplary aspect, there is provided a method of manufacturing a HT consumable and a HT consumable, wherein a membrane is glued to an inside circumferential face of an overhanging portion of a wrapping substrate that is wrapped around an aerosol-generating substrate. The membrane covers an end face of the aerosol-generating substrate. Advantageously, the membrane inhibits egress of the aerosol generating substrate from the consumable. Moreover, because the membrane is glued to an inside circumferential face of the overhang, an outer diameter of the consumable is unaffected. That is, the outside face of the consumable remains the wrapping substrate. Indeed, the overhanging combining paper acts as a restraint for the membrane to ensure alignment within the recess. There is therefore provided a method of manufacturing a HT consumable, comprising the steps of wrapping an aerosol-generating substrate in a wrapping substrate and forming a recessed end wherein a continuous portion of the wrapping substrate overhangs an end face of the aerosol-generating substrate. The method further comprises gluing a membrane to an inside circumferential face of the overhanging wrapping substrate.

There is then also provided an HT consumable wherein a wrapping substrate is wrapped around an aerosol-generating substrate, and wherein a membrane covers an end face of the aerosol-generating substrate. The membrane being adhered to an inside circumferential face of an overhanging portion of the wrapping substrate. As will be understood, where the wrapping substrate wraps around two components (i.e., the aerosol-generating substrate and a further component such as a hollow tube or the like), the wrapping substrate may be termed combining paper. Whilst combining paper is used herein, except where necessary, use of the term combining paper does not have an implicit requirement for the wrapping substrate to combine further components.

As will be appreciated, the overhanging portion of the combining paper may be formed by compressing an end of the tobacco or by gluing or suitably adhering a separate combining paper over an initial combining paper that circumscribes the aerosol generating substrate without an overhang, or by using an oversized combining paper, which when wrapped overhangs the end face. However, compressing the tobacco could change the density of the tobacco at the distal end leading to a localised change in airflow or another characteristic. Moreover, gluing an additional combining paper increases the outer diameter as well as creating potential misalignment. Also, using an oversized combining paper prevents two part-processed consumables from being formed by cutting through the combining paper, which reduces the production throughput. Therefore, in exemplary embodiments, the overhang can be formed as described above and herein. That is, by forming a part-processed consumable having a recessed distal end. The method therefore further comprises, prior to gluing the membrane, providing a width of combining paper and arranging a first aerosol-generating substrate and a second aerosol-generating substrate on the combining paper, wherein the respective aerosol-generating substrates are spaced apart. The method comprises the step of wrapping the combining paper around the aerosol-generating substrates and gap therebetween. The method subsequently comprises cutting the combining paper through the portion of the combining paper surrounding the gap to form two, part-processed HT consumables, wherein each part-processed HT consumable includes a recessed distal end.

In exemplary embodiments, the membrane is preferably perforated to allow airflow through the membrane and to/from the distal end of the aerosol-generating substrate (here, perforated includes mechanically puncturing the substrate, for instance by laser drilling or ablations as well as substrates that are porous). The perforations are suitably an array of holes through the membrane. The series of holes may be laser ablated perforations as described herein and, in particular, in relation to the perforations formed through the tipping paper to allow airflow into the cooling segment. Alternatively, the array of holes may be provided by utilising a mesh material as the membrane, where the mesh apertures are sized so as to substantially prevent aerosol-generating material from passing but to allow airflow.

An alternative to perforating the membrane is to perforate a circumferential side of the combining paper to allow airflow between the aerosol-generating substate through the sides of the consumable rather than through the distal end. Or the perforations through the circumferential side may be in addition to the perforated membrane. As will be appreciated whether side perforations are necessary or required will be determined by the structure of the HT device that the consumable is intended for use with. For instance, where the airflow passages are provided. Moreover, the same reasoning applies as to whether the perforated membrane is required, for instance because the HT device the consumable is intended for use with provides an airflow at the distal end.

In exemplary embodiments, the membrane is a sheet member such as paper or foil or the like. Here, the method may comprise supplying a sheet member (i.e., membrane) that is oversized to the aerosol-generating substrate. That is, the sheet member has a diameter larger that the diameter of the aerosol-generating member. Here, the sheet member is pushed into the combining paper such that edges of the sheet member fold and lay against the inside wall of the overhanging combining paper. Here, the method comprises applying glue to an edge region of the sheet member. Here the edge region is the oversized portion of the sheet member outside the diameter of the aerosol-generating substrate and therefore that folds against the inside surface as the sheet member is pushed into the combining paper.

In the exemplary embodiments, wherein the membrane is an oversized sheet member, the membrane may be preformed to assist the folding of the sides against the inside circumferential surface. For instance, the membrane may be performed with scores and / or cuts and / or removed portions. Suitably, the membrane is preformed to provide tabs about a central area. Here, the central area may substantially correspond to the size of the end face of the aerosol-generating substrate. In the embodiments where the membrane is perforated, it will be appreciated the central area comprises the perforations. The preformed tabs are configured to fold against the inside circumferential face of the overhanging combining paper. Glue can suitably be applied to the tabs prior to pushing the membrane into the recessed end of the part-processed consumable.

In some exemplary embodiments, the membrane comprises a central hole for receiving a heater. That is, in embodiments of the consumable configured for use with a HT device having a heater configured to penetrate the consumable (and in particular the aerosol-generating substrate), the membrane includes a hole therethrough to facilitate the entrance of the heater into the aerosol-generating substrate. Whilst the hole is envisaged as being greater than the perforations, and therefore providing an escape route for particles to exit the consumable, heaters are generally substantially smaller than the diameter of the aerosol-generating substrate. And therefore, the membrane still provides an increased reduction in the risk of aerosol-generating particles being pulled or falling from the consumable.

The membrane is preferably a sheet material. For instance, a flexible sheet material. In some examples the flexible sheet material is a paper or foil (e.g., aluminium foil) or the like. However, the membrane may also be other planar members such as discs that have a substantial thickness. Here, the substantial thickness of the disc allows glue to be applied between the circumferential face of the overhanging combining paper and the thickness of the disc. Examples of suitable discs include bore filters (single or multiple bore filters as are known in the art) or other filter elements. For instance, the membrane may be a disc comprised of cellulose acetate or polypropylene tow. In some arrangements, as described herein, the exemplary HT consumable is configured as an upstream consumable. That is, a consumable for use with a HT device having a cavity at an upstream end for receiving the consumable, an air passage through the device to a mouthpiece at a downstream end. Here, in the embodiments wherein the membrane is a disc, the disc may comprise a filter that includes flavourant (e.g., provided within a crush ball as is known in the art).

At its most general, the present invention provides a Heated tobacco (HT) system comprising a Heated Tobacco (HT) consumable having an end closed by a disc and a Heated Tobacco (HT) device configured with a heating zone that does not heat the end region of the consumable comprising the disc. By closing the end so that the tobacco portion is not exposed to a distal end, advantageously, a consumable is provided that reduces the risk or likelihood of tobacco from falling out or being pulled out from the consumable in use or during transportation and / or during the production process. Moreover, the device is configured not to heat the disc.

In the exemplary embodiments of the HT consumable wherein the membrane is a disc, it is preferable that the disc is not heated. That is, either for upstream consumables or downstream consumables, the HT device can be configured to not heat the distal end region of the consumable containing the disc. Consequently, in a further exemplary aspect there is provided a HT system comprising a HT consumable and a HT device. The HT consumable comprises an aerosol-generating substrate and a disc assembled to a distal end of the aerosol-generating substrate intended to be inserted into the device. Suitably the disc is assembled to the aerosol-generating substrate by wrapping substrate that wraps around the elements. Whilst the disc and aerosol-generating substrate may be formed by arranging the disc abutting the aerosol-generating substrate on the wrapping substrate, before wrapping the wrapping substrate around the elements, suitably the method and consumable comprise the method and consumable as described in other aspects and herein. As will be understood, where the wrapping substrate wraps around two components (i.e., the aerosol-generating substrate and a further component such as a hollow tube or the like), the wrapping substrate may be termed combining paper. Whilst combining paper is used herein, except where necessary, use of the term combining paper does not have an implicit requirement for the wrapping substrate to combine further components. The HT device comprises a housing having a cavity for receiving the consumable. A distal end of the cavity comprises a stop against which the consumable is pushed. Thus, abutting the consumable against the stop indicates the consumable is fully or correctly inserted into the cavity. The housing of the device houses a heater. The heater defines a heating zone, where the heating zone is an area of the cavity in which the heater provides heat. Here, the heating zone is arranged spaced from the stop and towards an entrance of the cavity.

In one exemplary embodiment, the heater is a resistive heater comprising a rod or blade that extends into the cavity. Here, the rod or blade is intended to be inserted through the disc and into the aerosol-generating substrate. Suitably the rod or blade includes an insulator portion and a heating portion, wherein the insulator portion is arranged between the stop and the heating portion. Thus, here, the heating zone of the resistive heater is spaced from the stop by the insulator portion, and the insulator portion can correspond to the disc to prevent unnecessary heating of the disc.

Other heaters are envisaged. For instance, a resistive heater or an infrared heater are envisaged in some embodiments as being arranged to heat the sides of the consumable. Here, the heater can be arranged to heat a zone spaced from the stop. That is, to not heat the distal end portion of the cavity corresponding to the area intended to be occupied by the disc. Alternatively, embodiments are envisaged wherein the heater is distributed on the consumable. For instance, in induction heaters wherein a susceptor is provided in the consumable and an electromagnetic source is provided about the cavity.

Here, the heating zone is defined by the susceptor and the susceptor in the exemplary embodiments would be arranged about the aerosol-generating substrate and not extend past or into the disc.

Suitably, the stop is formed by the closed end of the cavity. However, in some embodiments, it is envisaged that the stop is provided as a ledge or ridge within the cavity. In particular, in embodiments including a HT device having a cavity at an upstream end such that air is drawn through the aerosol-generating substrate and through the disc, the device can be configured to provide an airflow from the distal end of the cavity to a downstream mouthpiece on the device. Here, the distal end of the cavity can include a passageway. For instance, the passageway can be formed in a centre of a ledge. Here, a mesh can preferably be provided at the distal end of the cavity.

At its most general, the present invention provides a plurality of Heated Tobacco (HT) consumable having a closed end, wherein the ends are closed by pushing a membrane on to the consumable at a packer and once the consumables have been arranged into an array. By closing the end so that the tobacco portion is not exposed to a distal end, advantageously, a consumable is provided that reduces the risk or likelihood of tobacco from falling out or being pulled out from the consumable in use or during transportation and / or during the production process.

In a further exemplary aspect, there is provided a method of manufacturing a plurality of HT consumables, wherein a membrane is pushed onto a part-processed consumable. Advantageously, the plurality of HT consumables are first gathered and arranged into a matrix. It will be understood that this corresponds to a process on the packing machine as the consumables are gathered ready for packing.

Thus, in the exemplary embodiments, the method step is completed by the packer. Here, after arranging the plurality of part-processed consumables in the matrix array, an array of membranes are pushed simultaneously onto respective part-processed consumables. Advantageously, by pushing the membranes simultaneously onto the plurality of consumables in the array, for instance as part of the processing steps performed by the packer, the consumables are moving through the machine at a lower speed providing more convenient opportunity in the consumable processing to accommodate the pushing of the membranes.

Because the arranging and pushing step is carried out by the packer, the plurality of consumables can be maintained in the arrangement, after the membranes are pushed on, and until the consumables are packaged.

Suitably, the pushing of the membrane onto the part-processed consumables comprises pushing the membrane following the methods of other aspects described herein. Whilst the process of pushing the membrane may create the recess on the end of the part-processed consumable by compressing the tobacco, a particularly preferable method comprises first creating the recessed end part-processed consumable as herein described in other aspects.

At its most general, the present invention provides a Heated tobacco (HT) system comprising a Heated Tobacco (HT) consumable having an end closed by a foil membrane and a Heated Tobacco (HT) device configured with an infrared heater arranged at a distal end of a cavity for receiving the consumable. By closing the end so that the tobacco portion is not exposed to a distal end, advantageously, a consumable is provided that reduces the risk or likelihood of tobacco from falling out or being pulled out from the consumable in use or during transportation and / or during the production process. Furthermore, by closing the end with foil in combination with an infrared heater arranged at a distal end of the cavity, it is thought an improved infrared heating of the consumable can eb achieved.

In a further exemplary aspect, there is provided a HT system comprising a HT device and a HT consumable. The heated tobacco consumable comprises a closed end consumable having a foil membrane formed across and closing a distal end of the consumable. Here, the foil lays against an end face of an aerosol-generating substrate. It will be appreciated that a preferable method of forming the closed end consumable with a foil membrane is as herein described. And the features of the foregoing methods and consumables are therefore optional features in the present aspect. The HT device includes a housing that defines a cavity for receiving the consumable. The cavity has a closed distal end against which the consumable is pressed. The closed distal end forms an infrared heater. Here, the closed distal end comprises a material that is transparent to infrared heat. On an opposed side to which the heater is pressed is an infrared heating element. An infrared heating element is an element that when powered by electricity generates infrared radiation. For instance, the infrared heating element may be configured to generate more infrared radiation through the material forming the closed distal end of the cavity than heat conducted across the same material. Whilst infrared heating is a known alternative to a HT device having a resistive heating element, infrared heating from the distal end is prone to generating too much heat in the consumable. However, it has been found that a better heating of the aerosol-generating substrate can be achieved using a consumable having the distal end closed by a foil membrane. It is thought the foil membrane acts to reduce the heating effect and therefore provide an improved infrared heating.

Moreover, because the heater operates on infrared radiation being absorbed by the consumable from the outside, the HT device does not require a portion of the heater to penetrate the consumable. Thus, the closed end consumable is particularly beneficial by both closing the distal end of the consumable and reducing the risk of aerosol-generating substrate falling or being pulled from the consumable.

In some embodiments, the HT device having an infrared (IR) heater at the closed distal end of the cavity provides an airflow path between the closed distal end and the external environment. Here, the foil closing the distal end is suitably perforated. In the example of a downstream consumable, this airflow would be an inlet, where the HT device provides airflow through the device, end face of the aerosol-generating material and to the user via a downstream mouth end filter on the consumable. Alternatively, as described herein, where the HT device comprises a cavity at an upstream end such that air is drawn through the aerosol-generating substrate and through the foil, the airflow from the closed distal end of the cavity is an outlet providing the airflow to a downstream mouthpiece on the device. As will be appreciated, the foil can be perforated as herein described in relation to the previous aspects.

An alternative to perforating the foil is to perforate the circumferential side wall of the consumable (i.e. the sides of the combining paper that wraps the aerosol-generating substrate). Here, the HT device is configured to provide an airflow path to the sides of the cavity. In some embodiments, the airflow path can be provided by channels or flutes in the walls of the cavity. Alternatively, the airflow path can be provided through the housing.

At its most general, another aspect of the present invention provides a Heated Tobacco (HT) consumable wherein an end of the aerosol-generating substrate is closed by applying and curing a liquid to the distal end face of the aerosol generating substrate. By closing the end so that the tobacco portion is not exposed to a distal end, advantageously, a consumable is provided that reduces the risk or likelihood of tobacco from falling out or being pulled out from the consumable in use or during transportation and / or during the production process.

At its most general, another aspect of the present invention provides a Heated Tobacco (HT) consumable wherein an end of the aerosol-generating substrate is closed by applying and curing a liquid to at least a portion of an end face of an aerosol generating substrate. By closing the end face so that the tobacco portion is not exposed to a distal end, advantageously, a consumable is provided that reduces the risk or likelihood of tobacco from falling out or being pulled out from the consumable in use or during transportation and / or during the production process. In the exemplary embodiments, the liquid is applied to only a portion of the distal end face of the aerosol-generating substrate, and in particular to leave open voids through the cured liquid and aerosol generating substrate. Here, in some exemplary embodiments, the liquid is applied by brushing or a doctor blade or the like so that the liquid is not applied to voids in the end face of the aerosol-generating substrate. That is, the end face of the aerosol-generating substrate comprises voids between fibres and particles so that air can be drawn through the aerosol-generating substrate. The liquid is applied to tips of the fibres or particles without filling the voids therebetween at the end face. Consequently, airflow passages are maintained through the cured liquid and through the aerosol-generating substrate. Alternatively, the liquid can be applied in a pattern. For instance, by spraying. Here, the liquid does not fill the entire end face by virtue of the spray pattern.

Because the voids in the aerosol-generating substrate and the non-covered areas of the liquid from the spray pattern are random, it is believed the probability of applying the liquid to a sufficient number of voids in the aerosol-generating to substantially block airflow through the end face is minimal.

There is therefore provided a method of manufacturing a HT consumable comprising an aerosol-generating substrate having an end face, the method comprising applying a liquid to a portion of the end face and curing the liquid. Advantageously, the cured liquid acts to hold particles and fibres of the aerosol generating substrate together, which acts to reduce the risk of particles or fibres from falling out of the consumable. Here, preferably, the aerosol-generating substrate is wrapped in a wrapping substrate (i.e., combining paper, where combining paper only has a requirement to combine further components where otherwise necessary). The combining paper restrains the circumferential side wall of the aerosol-generating substrate. There is therefore also provided a HT consumable comprising an aerosol-generating substrate having an end face, wherein a liquid is cured on a portion of the end face.

In the exemplary embodiments, the liquid is an adhesive. Suitably the adhesive covers at least 50% or at least 60% or at least 70% or at least 80% of the distal end of the aerosol forming substrate whilst leaving open at least 50% or at least 60% or at least 70% or at least 80% of voids in the end face of the aerosol-generating substrate.

In some exemplary embodiments, once the glue has been applied, a disc or the like can be pressed onto the end of the consumable. Here, the disc is perforated to allow airflow therethrough. Again, the perforations are arranged to reduce the risk of a substantial portion of the openings from being covered by glue.

At its most general, another aspect of the present invention provides a Heated Tobacco (HT) consumable wherein a part of the electronics is distributed on the consumable. Advantageously, by inserting the consumable into a cavity of a HT device, the electronics distributed on the consumable can complete a circuit with electronics distributed on the device. This allows stick recognition. For instance, the device cannot be started without a correctly installed consumable because the circuit would not be complete. It also allows for an automatic switch on, with the smoking session started by inserting the consumable and completing the circuit without the requirement for further user interaction (such as the provision of a button). There is therefore provided a HT system comprising a heater circuit, the heater circuit comprising a battery, a heater, and electrical connections to connect the battery to the heater. The HT system comprises a HT device and a HT consumable, wherein the device includes electrical contacts that make contact with corresponding electrical contacts on the consumable when the consumable is inserted into a cavity in the device. The heater circuit is distributed across both the device and the consumable.

The electrical contacts on the consumable and device comprise part of the heater circuit. That is the heater circuit comprises the heater, battery, electrical connections and the electrical contacts.

In some exemplary embodiments, the heater is provided on the consumable and the battery is provided on the device. In other embodiments, the battery is provided on the consumable and the heater is provided on the device. In yet further embodiments, the heater and battery are provided on the same one of the device and consumable and the electrical connections are provided on the other of the device or consumable. In the embodiments wherein the heater and the battery are provided on the same component, there may be four corresponding electrical contacts on each of the device and consumable. But suitably, one of the anode or cathode of the battery and heater are connected directly on the same component, thus maintaining the requirement for only two electrical contacts on each component.

Whilst the electrical circuit may include a user interface such as a press button for the user to control the function of the system, for instance to start a smoking session or to select parameters of the smoking session such as heater temperature or the like as is known in the art, the system may be configured to automatically provide power from the battery to the heater on completion of the circuit. That is, by making electrical connections between the contacts on the device and corresponding contacts on the consumable, the heater circuit is completed, and the battery begins discharging to the heater.

Preferably, the electrical connections on the consumable may be a first electrical connection and a second electrical connection. For instance, an electrical anode and cathode. Preferably, each electrical connection on the consumable substantially circumscribes the consumable. For instance, each electrical connection is provided as a contact band or ring about the consumable. Suitably, the band or ring is arranged perpendicularly to a longitudinal axis of the consumable. The first electrical contact band is suitably spaced from the second electrical contact band by a predetermined distance. Consequently, the orientation of the consumable about the longitudinal axis and relative to the device is not required to make the electrical connection. At its simplest, the exterior surface of the consumable could be surface screen printed with metallic anode and cathode strips. For instance, combining paper that forms the outer surface of the consumable could be provided with electrically conductive bands by printing or other deposition or attachment techniques. Here, the electrically conductive bands are connected to the respective battery and / or heater and / or electrical connections. In some embodiments, the electrical connections are suitably covered by a paper layer or other insulating layer prior to packaging. Here, the user removes the covering prior to insertion of the consumable into the cavity. Advantageously, the covering prevents unintended electrical connection to the contacts.

Preferably, the electrical connections on the device have corresponding first and second electrical contacts that are provided a predetermined spacing from a stop. Here, the stop provides an abutment against which the consumable is pushed when being inserted into the cavity. As will be appreciated, the spacing between the stop and the respective first and second electrical contacts on the device can correspond to a spacing between an end of the consumable and the corresponding first and second electrical contacts on the consumable. Consequently, by pushing the consumable against the stop, the respective electrical connections can be aligned and mated. As explained in other aspects, the stop may be a closed end of the cavity or a shoulder or the like and features of the stop described in those aspects are applicable to this aspect also. For instance, the stop may include an aperture to an air passageway, and suitably, the aperture may be covered by a mesh or filter or the like. In some embodiments, the electrical contacts on the device are rings or bands. Alternatively, each electrical contact on the device comprises a sprung connection such as a pogo pin, where the resilient sprung biasing urges the connection against the electrical connections on the consumable. That is, the sprung connection can be restrained to move axially relative to the cavity and therefore consumable. Each electrical connection may comprise more than one sprung connection. For instance, where the contacts on the consumable are bands that include one or more bridges such that the bands form fully circles about the combining paper except for the bridges, by appropriate spacing of the two or more sprung connections, it can be ensured that even if one of the sprung connectors is rotationally aligned with a bridge (so that an electrical connection is not made), the other is ensured of not being aligned with a bridge and the electrical connection made.

In some embodiments, the battery is provided on the consumable. Here, a suitable battery comprises a biodegradable cellulose paper battery. Preferably, the battery is a thin paper battery which is wrapped around the consumable (e.g., in spiral shape to create airflow paths). That is, the thin paper battery can be formed on the combining paper, or the thin paper battery may be formed as a rod (i.e., wound into a rod shape) and joined to an aerosol-generating substrate or other elements of the consumable by combining paper. Advantageously, the airflow paths through the wrapped battery may form part of the airflow path through the system. Where the battery is arranged upstream of an aerosol-generating substrate of the consumable, the battery may act to pre-heat the incoming air. However, as will be appreciated, the device may be configured to provide airflow passages to sides of the consumable, where corresponding perforations through the sides of the consumable (i.e., perforations in the combining paper) can provide inlet air flow to the aerosol-generating substrate whilst bypassing the battery (i.e., not flowing over or around the battery).

In the exemplary embodiments having the heater on the device, the heater may be a resistive heater. For instance, the heater may include a rod or blade arranged in the cavity and for insertion into the consumable when inserted (so called inside out resistive heating). Alternatively, the heater may comprise resistive tracks about the sides of the cavity (so called outside in resistive heating). However, it is also envisaged that the heater may take alternative forms such as an infrared heater or an electromagnetic source (induction heater) for exciting a susceptor on the consumable.

In the exemplary embodiment, wherein the heater is provided on the consumable, suitably, the heater comprises a resistive track. The resistive track may wind around the consumable. Suitably, the resistive track is provided inside a combining paper of the consumable. For instance, the resistive track can be printed or deposited on the inside surface of the combining paper that wraps around an aerosol-generating substrate and possibly combines it with further elements as discussed herein. Alternatively, the resistive track may be formed as a separate element, for example in sheet form. Here the separate element can be laid on the combining paper before it is wrapped about the aerosol-generating substrate.

Suitably, the resistive track can be wound a plurality of times about the aerosol-generating substrate to provide the 'wind'. However, preferably the resistive track is wrapped about the aerosol-generating substrate to substantially circumscribe it (i.e. a single layer, but allowing for a glue overlap) or alternatively, the resistive track can be formed in a zig-zag or another wave type pattern along the length of the consumable so that when wrapped to circumscribe the consumable, the resistive track forms a plurality of loops with each loop completing a partial circle around the consumable before turning to travel a partial circle about the consumable in the opposed direction. Alternatively, the resistive track can form a wave shape in the width of the consumable so that, when the resistive track is wrapped to circumscribe the aerosol-generating substrate, the track travels longitudinally along the consumable in one direction before turning back and travelling longitudinally in the opposed direction.

In preferable embodiments wherein the resistive track is formed inside the combining paper that wraps the aerosol-generating substrate, preferably the electrical contacts are formed by exposing them through the combining paper. Here, the electrical contacts can be extensions of the resistive track. Moreover, suitably, the electrical contacts can be arranged such than when wrapped around the aerosol-generating substrate, the electrical contacts substantially circumscribe the aerosol-generating substate. In some embodiments, the contacts are exposed by mechanically exposing them through removal of a portion of the combining paper. Suitably, the mechanical exposure may comprise removing parts of the combining paper. That is, the combining paper may be removed by laser ablation (e.g., by ablating the combining paper over the electrical contacts. Alternatively, the combining paper may be removed by scraping the combining paper away from the electrical contacts. In some embodiments, the electrical contacts can be exposed through pre-formed apertures in the combining paper. In each case, the resistive track remains covered by the combining paper, whilst only the electrical contacts are exposed.

Consequently, at its most general, another aspect of the present invention provides a Heated Tobacco (HT) consumable wherein an electronic component is arranged between a wrapping substrate that wraps around an aerosol-generating substrate, wherein electrical contacts on the electronic component are exposed through the wrapping substrate. As will be understood, where the wrapping substrate wraps around two components (i.e., the aerosol-generating substrate and a further component such as a hollow tube or the like), the wrapping substrate may be termed combining paper. Whilst combining paper is used herein, except where necessary, use of the term combining paper does not have an implicit requirement for the wrapping substrate to combine further components.

In a further aspect there is provided a HT consumable comprising an aerosol-generating substrate wrapped in a combining paper, wherein a track is arranged between the aerosol-generating substrate and the combining paper. Preferably the track is an electrically conductive track. Here, the electrical contacts are parts of the track exposed through the combining paper. Since only the electrical contacts are exposed through the combining paper (i.e., the resistive track that connects the contacts remains between the combining paper and aerosol-generating substrate) the combining paper covers and protects the conductive track. Preferably, the electrical contacts are exposed through bands in the combining paper. The bands may fully encircle the combining paper, or the bands may substantially encircle the combining paper such that one or more bridges are maintained through the bands. Suitably, the bands are concentric and spaced from each other. The track may be part of a resistive heater such that the electrically conductive track is a resistive track that generates heat when a battery is discharged therethrough or the electrically conductive track may be part of a battery, such as a paper battery.

There is also then provided a method of manufacturing a HT consumable, wherein the method comprises providing a combining paper and subsequently laying a resistive track on the combining paper followed by subsequently placing an aerosol-generating substrate over the resistive track. The method then comprises wrapping the combining paper about the aerosol-generating substrate. The method further comprising exposing electrical contacts of the resistive track through the combining paper. Preferably, the step of exposing the electrical contacts may comprise mechanically removing the combining paper from covering the electrical contacts. Alternatively, apertures may be preformed in the combining paper and the step of placing the resistive track comprises aligning electrical contacts on the resistive track with the apertures, such that when wrapped about the aerosol-generating substrate, the electrical contacts are exposed through the pre-formed apertures in the combining paper.

The exemplary consumable embodiments are applicable to a downstream consumable (i.e., where the consumable includes a downstream mouthpiece and the consumable is inserted into the cavity in a downstream to upstream direction). The exemplary embodiments are also applicable to upstream consumables (i.e., where the device includes the downstream mouthpiece and the consumable is inserted into the consumable in an upstream to downstream direction), and the exemplary consumables are therefore also able to form an exemplary system comprising the consumable and a HT device of the following aspect.

At its most general, another aspect of the invention provides a Heated Tobacco (HT) device wherein the cavity is provided at an upstream end. Here, the HT device includes a mouthpiece and a cavity wherein the mouthpiece is interconnected with the cavity via an airflow passageway through the device. The cavity is arranged at an upstream end of the device with the mouthpiece forming a downstream end of the device. Suitably the upstream end is opposed to the downstream end. For instance, suitably the device has a generally elongate form having a longitudinal axis, wherein the mouthpiece and cavity are concentric with the longitudinal axis. In other words, the cavity being provided at an upstream end of the device means a consumable is inserted into the cavity in a upstream to downstream direction. Whereas the HT devices described in the background section might be termed downstream devices, wherein the consumable is inserted into the cavity in the opposed downstream to upstream direction and wherein the consumable includes a mouthpiece. Advantageously, by configuring the HT device as an 'upstream' device, the mouthpiece is provided on the device and the device provides the downstream airflow passage from the aerosol-generating substrate. Thus, the device can be configured to have more or different options on the airflow passage than might be available on a downstream configuration wherein the downstream airflow from the aerosol-generating substrate is provided on the consumable.

There is therefore provided a HT device having a housing that defines a mouthpiece, a cavity and an airflow passage interconnecting the mouthpiece and cavity. Here, the cavity is configured for receiving a consumable by inserting the consumable into the cavity in an upstream to downstream direction. There is also provide an HT system comprising the HT device and a HT consumable. The HT consumable includes an aerosol-generating substrate and may be a consumable in accordance with the previous aspects or a combination of compatible features of the previous aspects. Since in the present aspect where the consumable is upstream, the airflow through the consumable and into the airflow passage acts to pull or bias aerosol-generating particles out of the distal end of the consumable, consumables having closed ends are particularly relevant. Moreover, a mouthpiece is not required on the consumable.

In the exemplary embodiments, the mouthpiece is shaped for a user to comfortably puff thereon. Suitably, the mouthpiece comprises an exit from the airflow passage. The exit may be centrally located on the mouthpiece.

In the exemplary embodiments, the airflow passageway is sealed by the housing between the mouthpiece and the cavity. Suitably, the airflow passage may be in communication with a closed distal end of the cavity. Here, consumables having perforations through a closed distal end are particularly relevant. Also, here, suitably, the airflow passage is substantially liner and preferably coincident with a general longitudinal axis of the body. Alternatively, the airflow passage may be in communication with a side wall of the cavity (i.e., a circumferential wall). Here, the passageway may include bends or elbows or the like so that not all portions of the airflow passageway are substantially coaxial or parallel to the generally longitudinal axis of the body. The downstream airflow passage provided in the device acts to cool and condition the generated aerosol. Thus, the device may provide baffles or the like. Moreover, the device may comprise means for inserting capsules or the like such as flavour capsules in the airflow passage.

In exemplary embodiments, the cavity of the device includes a stop. As with previous aspects, the stop acts as an abutment against which the consumable is pushed to fully and correctly insert the consumable.

The stop can therefore provide a reference point to correctly, longitudinally position respective features on the device and the consumable. The stop may be a closed distal end of the cavity or may be a ledge or the like. Thus, the stop may be in accordance with the stop of other aspects and those features are therefore envisaged as being relevant to this aspect. In particular, the embodiments wherein the stop is a ledge defining an entrance to the airflow passage (i.e., a closed distal end with central aperture forming the stop as an annular ledge), preferably a mesh is provided to cover the entrance. That is, the entrance may be an aperture (e.g., a central aperture) and the mesh is arranged to cover the aperture. Here, the mesh acts as a restraint to aerosol-generating particles being pulled through the device with the airflow.

Again, the mesh may be in accordance with the mesh of other aspects. Moreover, as an alternative to a mesh, the closed distal end of the cavity may be perforated with a plurality of apertures. For instance, an array or matrix of small apertures to replicate a mesh. However, a mesh may be preferable as it can allow for removal of the mesh during cleaning or replacement.

In the exemplary embodiments of the upstream device, a system is provided by a combination of the HT device and a consumable. The consumable suitably has a closed end. Thus, the closed end may be in accordance with other aspects. In particular, the closed end may have a membrane. Because in these embodiments, the consumable does not require a mouthpiece filter, both ends of the aerosol-generating substrate may be finished or connected to identical components. For instance, both ends may have folded closed ends or membranes closing the ends.

Consequently, at its most general, the present invention provides a Heated tobacco (HT) system comprising a Heated Tobacco (HT) consumable having end-to-end symmetry and a Heated Tobacco (HT) device configured with a cavity for receiving the consumable in an upstream to downstream direction.

Thus according to an aspect, there is provided a consumable that has end-to-end symmetry. That is, the consumable is arranged to operate in the same manner independent of which end is inserted into the device. End-to-end symmetry simplifies the use as the user does not need to identify the correct end to be inserted (i.e., either the upstream end of the consumable or the downstream end of the consumable). Suitably, both ends of the consumable are closed. Herein a 'closed end' of a consumable refers to an end face of the aerosol-generating substrate not being exposed. That is the end face of the aerosol-generating substrate is closed.

Of course, preferably, where the consumable has an elongate shape, and preferably a rod shape (i.e., the consumable forms a substantially cylindrical outer shape), the upstream and downstream ends of the consumable can be air-permeable to allow an axial airflow through the consumable. Thus, in exemplary embodiments, the closed ends are both permeable to air. Here, suitably the ends are closed by perforated or mesh type features as herein described.

In the exemplary HT devices, and in relation to the HT consumables, HT devices that the consumables are intended for use with, the HT device may comprise any one or more of the following exemplary features, except where those features are incompatible with the disclosed aspect. This applies for both HT devices configured with a cavity configured to allow insertion of the consumable in the upstream and downstream direction.

Suitably, the device may comprise an elongate housing (also referred to as a body). An end of the elongate body may be configured for engagement with a consumable. For example, the body is configured for engagement with a heated tobacco consumable. Exemplary devices comprise a cavity that is configured for receipt of at least a portion of the consumable (i.e., for engagement with the consumable). As explained, the aerosol-forming article is of the type that comprises an aerosol former (e.g., carried by an aerosol-generating substrate).

Exemplary devices comprise a heater for heating the aerosol-generating substrate.

In exemplary embodiments, the heater (and thus the heating element) is rigidly mounted to the body. The heating element may be elongate so as to define a longitudinal axis and may, for example, have a transverse profile (i.e., transverse to a longitudinal axis of the heating element) that is substantially circular (i.e., the heating element may be generally cylindrical). Alternatively, the heating element may have a transverse profile that is rectangular (i.e., the heater may be a "blade heater"). The heating element may alternatively be in the shape of a tube (i.e., the heater may be a "tube heater"). The heating element may take other forms (e.g., the heating element may have an elliptical transverse profile). The shape and/or size (e.g., diameter) of the transverse profile of the heating element may be generally consistent for the entire length (or substantially the entire length) of the heating element.

In exemplary embodiments, the heating element is between 15 mm and 25 mm long, e.g., between 18 mm and 20 mm long, e.g., around 19 mm long. The heating element may have a diameter of between 1.5 mm and 2.5 mm, e.g., a diameter between 2 mm and 2.3 mm, e.g., a diameter of around 2.15 mm.

The heating element may be formed of ceramic. The heating element may comprise a core (e.g., a ceramic core) comprising Al2O3. The core of the heating element may have a diameter of 1.8 mm to 2.1 mm, e.g., between 1.9 mm and 2 mm. The heating element may comprise an outer layer (e.g., an outer ceramic layer) comprising AI2O3. The thickness of the outer layer may be between 160 µm and 220 µm, e.g., between 170 µm and 190 µm, e.g., around 180 µm. The heating element may comprise a heating track, which may extend longitudinally along the heating element. The heating track may be sandwiched between the outer layer and the core of the heating element. The heating track may comprise tungsten and/or rhenium. The heating track may have a thickness of around 20 µm.

In exemplary embodiments, the heating element is located in the cavity (of the device), and may extend (e.g., along a longitudinal axis) from an internal base (i.e., distal end) of the cavity towards an opening of the cavity. The length of the heating element (i.e., along the longitudinal axis of the heater) may be less than the depth of the cavity. Hence, the heating element may extend for only a portion of the length of the cavity. That is, the heating element may not extend through (or beyond) the opening of the cavity.

Optionally, the heater comprises a heating element in the form of a rod or blade that extends from the body and into the cavity. That is, the heating element extends from an end of the body that is configured for engagement with the consumable. Here, the heating element is configured for insertion into an aerosol-forming article (e.g., a HT consumable) when an aerosol-forming article is received in the cavity. In that respect, a distal end (i.e., distal from a base of the heating element where it is mounted to the device) of the heating element may comprise a tapered portion, which may facilitate insertion of the heating element into the aerosol-forming article. The heating element may fully penetrate an aerosol-forming article when the aerosol-forming article is received in the cavity. That is, the entire length, or substantially the entire length, of the heating element may be received in the aerosol-forming article.

The heating element may have a length that is less than, or substantially the same as, an axial length of an aerosol-generating substrate forming part of an aerosol-forming article (e.g., a HT consumable). Thus, when such an aerosol-forming article is engaged with the device, the heating element may only penetrate the aerosol-generating substrate, rather than other components of the aerosol-forming article. The heating element may penetrate the aerosol-generating substrate for substantially the entire axial length of the aerosol forming-substrate of the aerosol-forming article. Thus, heat may be transferred from (e.g., an outer circumferential surface of) the heating element to the surrounding aerosol-generating substrate, when penetrated by the heating element. That is, heat may be transferred radially outwardly (in the case of a cylindrical heating element).

Alternatively, the heater can be configured to transfer heat radially inwardly (in the case of a tube heater). In exemplary embodiments where the heater is a tube heater, the heating element of the tube heater may surround at least a portion of the cavity. When the portion of the aerosol-forming article (i.e., HT consumable) is received in the cavity, the heating element surrounds a portion of the aerosol-forming article (i.e., so as to heat that portion of the aerosol-forming article, for instance the aerosol-generating substrate). In particular, the heating element may surround an aerosol-generating substrate of the aerosol-forming article. That is, when an aerosol-forming article is engaged with the device, the aerosol-generating substrate of the aerosol-forming article may be located adjacent an inner surface of the (tubular) heating element. When the heating element is activated (by discharging a battery across the heater), heat may be transferred radially inwardly from the inner surface of the heating element to heat the aerosol forming substrate.

In exemplary embodiments where the heater is a tube heater, the cavity comprises a (e.g., circumferential) wall (or walls) and the (tubular) heating element extends around at least a portion of the wall(s). In this way, the wall may be located between the inner surface of the heating element and an outer surface of the aerosol-forming article. The wall (or walls) of the cavity may be formed from a thermally conductive material (e.g., a metal) to allow heat conduction from the heating element to the aerosol-forming article. Thus, heat may be conducted from the heating element, through the cavity wall (or walls), to the aerosol-generating substrate of an aerosol-forming article received in the cavity.

Alternatively, here, the heating element may be an infrared (IR) heating element. A tubular IR heating element may be configured to emit more IR radiation across the wall (or walls) than is transmitted by conduction. The wall (or walls) is therefore suitably transmissive of the emitted IR radiation. The combination of the wall (or walls) with the tubular IR heating element may be referred to as an IR heating tube. That is, in exemplary embodiments, the cavity may be formed from an IR heating tube.

The device may further comprise a provision, preferably a mechanical means, to intrude into the cavity. For instance, o-rings or the like that are configured to slightly compress against the inserted consumable in order to grip the consumable and provide resistance to withdrawal (and in relation to the upstream configured cavities, to prevent the consumable falling out under gravity in use). In embodiments comprising electrical connections between the device and the consumable, the electrical connections may provide the resistance to withdrawal of the consumable, or additional assist in doing so.

In some exemplary embodiments the device comprises a cap disposed at the end of the body that is configured for engagement with the consumable. Where the device comprises a heater having a heating element configured to be inserted into the consumable, the cap may at least partially enclose the heating element. The cap may be moveable between an open position in which access is provided to the heating element, and a closed position in which the cap at least partially encloses the heating element. The cap may be slideably engaged (i.e., slid to engage) with the body of the device, and may be slideable (i.e., able to slide) between the open and closed positions. In the alternative, rather than or additional to opening and closing the cavity, the sliding between the open and closed position may act to lift the consumable from heating element.

In exemplary embodiments, the cap defines at least a portion of the cavity of the device. That is, the cavity may be fully defined by the cap, or each of the cap and body may define a portion of the cavity. Where the cap fully defines the cavity, the cap may comprise an aperture for receipt of the heating element into the cavity (when the cap is in the closed position). The cap may comprise an opening to the cavity. The opening may be configured for receipt of at least a portion of the consumable (and preferably at least the portion including the aerosol-generating substate). That is, the consumable may be inserted through the opening and into the cavity (so as to be engaged with the device).

In exemplary embodiments, the cap is configured such that when a consumable is engaged with the device (e.g., received in the cavity), only a portion of the consumable is received in the cavity. That is, a portion of the consumable (not received in the cavity) may protrude from (i.e., extend beyond) the opening. In embodiments wherein the cavity is an upstream cavity, this (protruding) portion of the consumable is a terminal (e.g., mouth) end of the consumable, which is received in a user's mouth for the purpose of inhaling aerosol formed by the system.

In exemplary embodiments, the device comprises a power source or may be connectable to a power source (e.g., a power source separate to the device). Here, the power source is electrically connectable to the heater. In that respect, altering (e.g., toggling) the electrical connection of the power source to the heater may affect a state of the heater. For example, toggling the electrical connection of the power source to the heater may toggle the heater between an on state and an off state (e.g., PWM control). The power source may be a power store. For example, the power source may be a battery or rechargeable battery (e.g., preferably a lithium-ion battery).

In exemplary embodiments, the device comprises an input connection (e.g., a USB port, Micro USB port, USB-C port, etc.). The input connection may be configured for connection to an external source of electrical power, such as a mains electrical supply outlet. The input connection may, in some cases, be used as a substitute for an internal power source (e.g., battery or rechargeable battery). That is, the input connection may be electrically connectable to the heater (for providing power to the heater). Hence, in some forms, the input connection may form at least part of the power source of the device. Where the power source comprises a rechargeable power source (such as a rechargeable battery), the input connection may be used to charge and recharge the power source.

In exemplary embodiments, the device comprises a user interface (Ul). In some embodiments the Ul may include input means to receive operative commands from the user. The input means of the Ul may allow the user to control at least one aspect of the operation of the device. In some embodiments the input means may comprise a power button to switch the device between an on state and an off state. In some embodiments the Ul may additionally or alternatively comprise output means to convey information to the user. In some embodiments the output means may comprise a light to indicate a condition of the device (and/or the aerosol-forming article) to the user. The condition of the device (and/or aerosol-forming article) indicated to the user may comprise a condition indicative of the operation of the heater. For example, the condition may comprise whether the heater is in an off state or an on state. In some embodiments, the UI unit may comprise at least one of a button, a display, a touchscreen, a switch, a light, and the like. For example, the output means may comprise one or more (e.g., two, three, four, etc.) light-emitting diodes ("LEDs") that may be located on the body of the device. In some exemplary embodiments, the device may further comprise a puff sensor (e.g., airflow sensor), which form part of the input means of the UI. The puff sensor may be configured to detect a user drawing on an end (i.e., a terminal (mouth) end) of the system. The puff sensor may, for example, be a pressure sensor or a microphone. The puff sensor may be configured to produce a signal indicative of a puff state. The signal may be indicative of the user drawing (an aerosol from the consumable) such that it is e.g., in the form of a binary signal. Alternatively, or additionally, the signal may be indicative of a characteristic of the draw (e.g., a flow rate of the draw, length of time of the draw, etc).

In exemplary embodiments, the device comprises a controller, or may be connectable to a controller that may be configured to control at least one function of the device. The controller may comprise a microcontroller that may e.g., be mounted on a printed circuit board (PCB). The controller may also comprise a memory, e.g., non-volatile memory. The memory may include instructions, which, when implemented, may cause the controller to perform certain tasks or steps of a method. Where the device comprises an input connection, the controller may be connected to the input connection. The controller may be configured to control the operation of the heater (and e.g., the heating element). Thus, the controller may be configured to control vaporisation of an aerosol forming part of an aerosol-forming article engaged with the device. The controller may be configured to control the voltage applied by power source to the heater. For example, the controller may be configured to toggle between applying a full output voltage (of the power source) to the heater and applying no voltage to the heater. Alternatively, or additionally, the control unit may implement a more complex heater control protocol. In exemplary embodiments, the controller includes a voltage regulator to regulate the output voltage supplied by the power source to form a regulated voltage. The regulated voltage may subsequently be applied to the heater.

In some embodiments, where the device comprises a UI, the controller may be operatively connected to one or more components of the UI. The controller may be configured to receive command signals from an input means of the UI. The controller may be configured to control the heater in response to the command signals. For example, the controller may be configured to receive "on" and "off' command signals from the UI and, in response, may control the heater so as to be in a corresponding on or off state. The controller may be configured to send output signals to a component of the Ul. The UI may be configured to convey information to a user, via an output means, in response to such output signals (received from the controller). For example, where the device comprises one or more LEDs, the LEDs may be operatively connected to the controller. Hence, the controller may configured to control the illumination of the LEDs (e.g. in response to an output signal). For example, the controller may be configured to control the illumination of the LEDs according to (e.g., an on or off) state of the heater.

Where the device comprises a sensor (e.g., a puff/airflow sensor), the controller may be operatively connected to the sensor. The controller may be configured to receive a signal from the sensor (e.g., indicative of a condition of the device and/or engaged aerosol-forming article). The controller may be configured to control the heater, or an aspect of the output means, based on the signal from the sensor.

In some exemplary embodiments, the device may comprise a wireless interface configured to communicate wirelessly (e.g., via Bluetooth (e.g., a Bluetooth low-energy connection) or WiFi) with an external device. Similarly, the input connection may be configured for wired connection to an external device so as to provide communication between the device and the external device. The external device may be a mobile device. For example, the external device may be a smart phone, tablet, smart watch, or smart car. An application (e.g., app) may be installed on the external device (e.g., mobile device). The application may facilitate communication between the device and the external device via the wired or wireless connection. The wireless or wired interface may be configured to transfer signals between the external device and the controller of the device. In this respect, the controller may control an aspect of the device in response to a signal received from an external device. Alternatively, or additionally, an external device may respond to a signal received from the device (e.g., from the controller of the device).

As used herein, the terms "upstream" and "downstream" are intended to refer to the flow direction of the vapour/aerosol i.e. with the downstream end of the article/consumable being the mouth end or outlet where the aerosol exits the consumable for inhalation by the user. The upstream end of the article/consumable is typically the opposing end to the downstream end. That is, where the airflow through the component or the system is substantially straight, the upstream end will be opposed to the downstream end. Where air inlets might be provided on the sides of the component, the downstream end is defined by the exit of the aerosol to the user and the upstream end is generally an opposed region including the inlets.

### SUMMARY OF THE FIGURES

So that the invention may be understood, and so that further aspects and features thereof may be appreciated, embodiments illustrating the principles of the invention will now be discussed in further detail with reference to the accompanying figures, in which:
**Figure 1** shows a schematic plan view of a processing step in the manufacture of a consumable;
**Figure 2** shows a cross section through a part-processed consumable having a recessed end;
**Figure 3** shows fold options a-c for folding combining paper to close an end of the consumable of Fig 2;
**Figure 4** shows an end view of the end face of the recessed end of Figure 2;
**Figure 5** shows a pictorial view of a process of pushing a membrane on to the end of a consumable;
**Figure 6** shows a cross-sectional perspective view through an exemplary consumable;
**Figure 7** shows an exemplary consumable prior to electrical contacts being exposed;
**Figure 8** shows the consumable of Fig 7 with the electrical contacts exposed;
**Figure 9** shows the consumable of Fig 7 without the combining paper;
**Figure 10** shows an unwrapped combining paper with a resistive track formed thereon;
**Figure 11** shows a perspective view of a system comprising a device and a connected consumable
**Figure 12** shows a schematic view of the system of Fig 11;
**Figure 13** shows a pictorial view of the system of Fig 11 wherein the consumable is separated from the device; and
**Figure 14** shows a view of the consumable of Figs 11, 12 and 13.

### DETAILED DESCRIPTION OF THE INVENTION

Aspects and embodiments of the present invention will now be discussed with reference to the accompanying figures. Further aspects and embodiments will be apparent to those skilled in the art. All documents mentioned in this text are incorporated herein by reference.

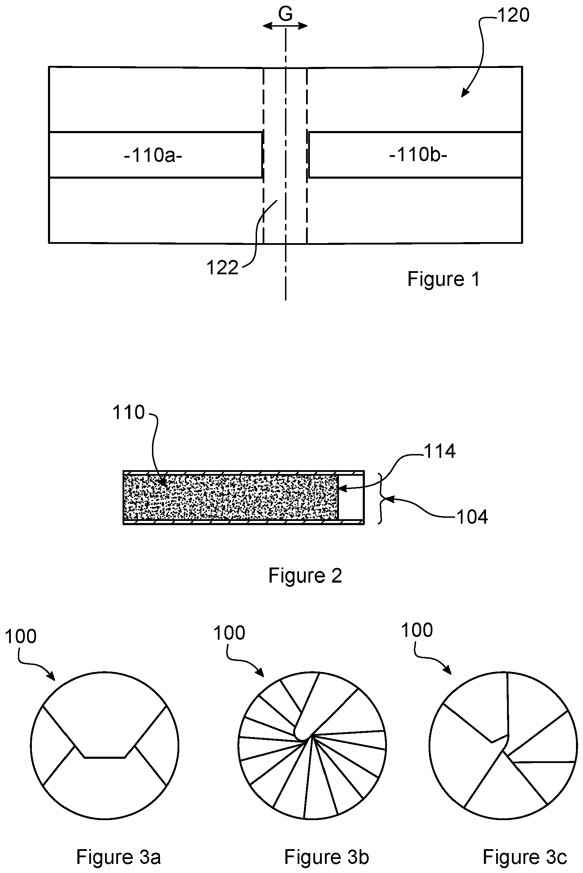

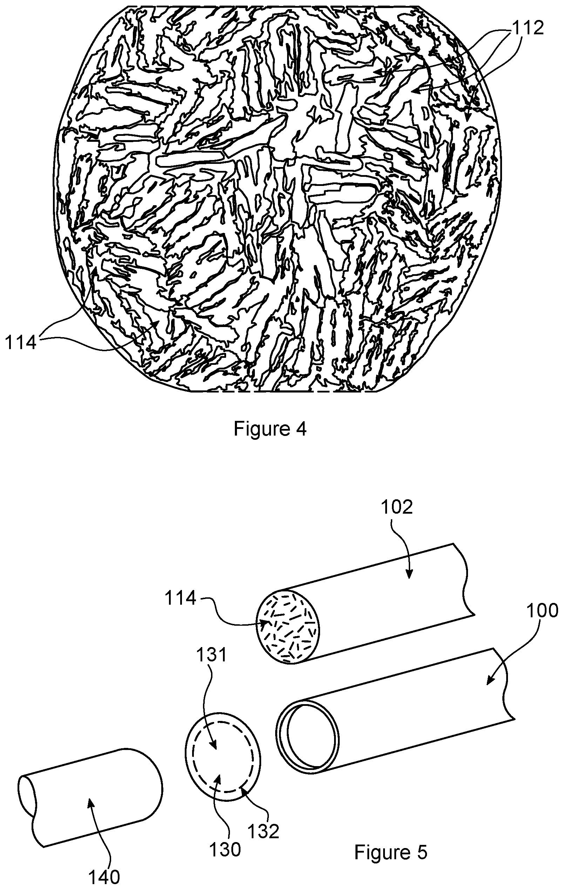

Referring to Figures 1 to 4 there is shown a Heated Tobacco (HT) consumable 100. Here, the consumable comprises at least an aerosol-generating substrate 110. The aerosol-generating substrate is suitably formed into a cylindrical rod. The cylindrical rod has a longitudinal axis. In the exemplary embodiments, the aerosol-generating substrate 110 is a tobacco rod 110, and although herein the aerosol-generating substrate will be referred to as a tobacco-rod, references to tobacco rod equally apply to the encompassing generic term aerosol-generating substrate. Suitably, the tobacco rod 110 is formed from reconstituted tobacco. The processing of tobacco material in the preparation of reconstituted tobacco (recon) by means of a paper-making process is well known in the art as exemplified by Canadian Pat. No. 862,497 which has been incorporated herein by reference. The processes therein described are particularly advantageous with the paper-making process for preparing reconstituted tobacco material ("recon") sheets. A carrier is added to the recon to assist in the aerosol formation to allow the consumable to be specifically adapted to operate as a HT consumable. The recon is prepared in a strip maker and gathered into a rod. As shown in Figure 4, the tobacco rod therefore comprises multiple parallel strips 112 of the cut recon running parallel to the longitudinal axis. Consequently, in Figure 4, only the cut tips of the strips 112 are seen. Although the strips can be tightly packed, voids 114 are left between adjacent strips. As will be appreciated, the voids provide air flow passages through the tobacco rod 110.

In Figure 2, a part-processed consumable 102 is shown wherein the tobacco rod 110 has been wrapped by a combining paper 120. Whilst the combining paper 120 may in some embodiments also wrap and combine further elements to the tobacco rod 110, it is only shown in Figure 2 circumscribing the tobacco rod. As shown, the part-processed consumable 102 comprises a recessed end 104. Here, an end face 114 of the tobacco rod 110 is shown recessed relative to an end plane of the combining paper 120. That is a portion of the combining paper overhangs the end face 114. Suitably, the portion of the combining paper that overhangs the end face 114 is cylindrical.

Referring to Figure 1, an exemplary method of manufacturing the part-processed consumable 102 of Figure 2 is shown. Here, a combining paper 120 is provided and a first tobacco rod 110a and second tobacco rod 110b are placed on the combining paper. The first and second tobacco rods are coaxially aligned, but are spaced by a gap G. That is, a cut end face of one tobacco rod 110a is spaced in a longitudinal direction from a cut end of the other tobacco rod 110b to create a spacing or gap between the respective end face 114. In the exemplary embodiments, each of the tobacco rods is a single length, that is a length of tobacco rod intended for a single consumable.

The method comprises wrapping the combining paper around the two tobacco rods 110 as is known in the art for wrapping a double length tobacco rod. For instance, the wrapping step may include a gluing and curing step to secure the combining paper 120. There is therefore formed a unit comprising the combining paper and the two spaced tobacco rods. By cutting the combining paper 120 through the gap G, the unit is turned into two part-processed consumables (and suitably, two identical part-processed consumables).

As shown in Figure 1, optionally, a portion 122 of the combining paper that aligns with the gap G, and preferably a central portion, is perforated. The combining paper may be pre-perforated. Or the perforations may be applied after the unit is formed by wrapping the combining paper about the tobacco rods. For instance, the perforations can be formed by laser ablation as is known in the art for forming the ventilation perforations into the downstream cooling segments. Thus, the perforations may be a plurality of holes sized to prevent tobacco particles or fibres from passing, but to enable airflow. The perforations may be spaced longitudinally and axially along the portion 122 of the combining paper.

Once the unit is formed and the portion 122 perforated, the method comprises cutting through the combining paper in the region 122. Thus, separating the unit into two part-processed consumables 102 one of which is shown in Figure 2. Preferably, the portion 122 is cut along the middle of the gap so that the two part-formed consumables are substantially identical. It will therefore be appreciated that the gap G is predetermined as twice the length if the required overhang on each part-processed consumable 102.

The part-processed consumable 102 shown in Figure 2 is further processed to form the consumable 100 by closing the distal end portion. However, it will be understood that there may be further processing steps in exemplary embodiments, for instance to combining of further segments or elements such as filters and cooling segments or tubes.

One exemplary embodiment of closing the part-processed consumable 102 shown in Figure 2 is to fold the overhanging combining paper over the end face 114. Here, as shown in Figure 3, a number of fold methods are envisaged. Figure 3a shows an example wherein the overhanging combining paper has been crushed to fold the combining paper over the end face 114. In figure 3b, the overhanging portion of combining paper has been folded in an 'envelope' fold or 'letter box' fold where a first side is folded in, followed by an opposed side, followed by the remaining sides. Here, the combining paper may be prescored prior to the wrapping step to provide fold lines for the envelope fold. In Figure 3c, the overhang portion of the combining paper 120 has been cut to produce a plurality of fingers 124. For instance, the combining paper can be cut, and apertures formed by removing segments of the combining paper prior to the wrapping step. The removed segments are such that when cut, the fingers are formed. The fingers can then be folded in a sequential or other order to create a 'iris'.

In order to cover the end face, a length of the overhang may be substantially similar or greater than the radius of the tobacco rod 110. However, it will be appreciated that if the overhang is too long there will be too much material to fold. Therefore, the length of the overhang may be less than 75% or less than 70% or less than 60% or less than 55% of the diameter of the tobacco rod 110.

Adhesive may be used to prevent the combining paper unfolding. Also, if the consumable is intended in use to be penetrated by a heater, the overhanging combining paper can be shaped such that when folded an aperture remains through the folds. The aperture may suitably be a central aperture.

Referring to Figure 5, an exemplary method of manufacturing a heated tobacco consumable 100 is shown. Here a membrane 130 is pushed onto a part-processed consumable comprising a combining paper 120 wrapping a tobacco rod 110 and wherein the membrane 130 is glued to an inside surface of the combining paper 120. The process of pushing the membrane 130 onto the part-formed consumable 102 may act to compress the tobacco at the distal end, wherein compressing the tobacco causes a portion of the combining paper 120 to overhang or protrude from an end face of the (now compressed) tobacco. Alternatively, the membrane is pushed onto the part-processed consumable 102 as shown and described in relation to Figures 1 to 4 above.

In Figure 5, the membrane 130 is shown as being a sheet 131. For instance, the sheet may be a paper or foil. Due to the tobacco rod 110 being cylindrical, it will be appreciated that the sheet is also shown as a circle, wherein the sheet has a central area that corresponds to the cross-sectional shape of the tobacco rod 110. The sheet is oversized relative to the tobacco rod 110. Thus, an edge region 132 of the sheet extends past the diameter of the tobacco rod 110 when the two are centred. Here, glue is applied to the edge region. Consequently, glue is not applied to the central area that overlies and closes the end face 114 of the tobacco rod 110. It will be appreciated that as the oversized membrane is pushed onto the part-processed consumable, the edge region contacts the combining paper. Thus, the edge region is caused to fold against the sides of the internal surface of the combining paper. A pushing rod 140, and suitably a metal pushing rod, is shown as pushing the sheet into the overhanging combining paper 120.

In some embodiments, the membrane 130 is perforated. For instance, the membrane 130 may be perforated with an array of holes sized to prevent tobacco fibres or particles from passing from the tobacco rod 110 but to allow airflow. The array of holes in envisaged as being a matrix that extends substantially across the area of the membrane. In other embodiments, the membrane may additionally or alternatively be formed with an aperture for receiving a heater. As will be appreciated, the aperture is envisaged as being a central aperture and sized so as to receive, for instance a resistive heater rod or blade.

Whilst the membrane may be pushed onto the part-processed consumable 102 individually, for instance on the combiner, preferably, a plurality of membranes are pushed onto the part-processed consumable simultaneously. Here, a plurality of consumables are first arranged in an array. Since this corresponds to a step on the packer, it is envisaged the step of pushing a plurality of membranes onto the plurality of part-processed consumables can be carried out at the packer. Here, because the consumables move together, they move at a lower speed than when individually arranged on the combiner. Therefore, completing the pushing step on the packer is advantageous. In the envisaged embodiments, the simultaneous pushing step will be completed by a plurality of pushers moving simultaneously and therefore arranged in a corresponding array.

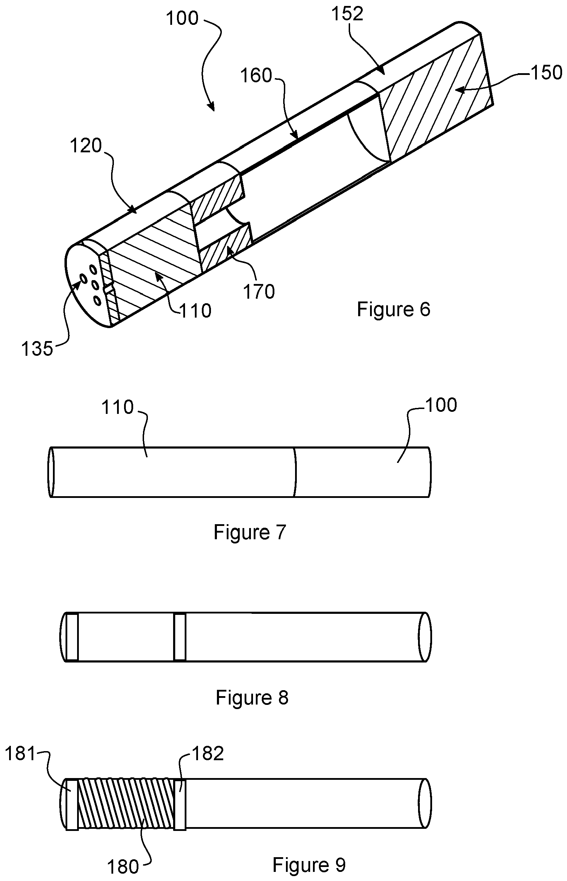

Figure 6 shows an exemplary heated tobacco consumable 100. The consumable is intended to be inserted into a cavity in a downstream to upstream direction such that a mouthpiece 150 is provided at an upstream end of the consumable with a spacer 160 and bore filter 170 arranged between the mouthpiece and tobacco rod 110. As is known, the elements can be variously circumscribed by combining paper 120 and tipping paper 152. In figure 6, a membrane shown as a disc 135 is attached to the end face of the tobacco rod. Suitably, the disc 135 is a metal cap. But other discs are considered. For instance, the disc may be a mesh or a bore filter or the like. Unlike where the membrane is a paper or foil, the discs have sufficient edge thickness for glue to be applied directly. Moreover, advantageously, the discs may be configured to have sufficient thickness to accommodate flavouring members such as fractureable liquid capsules.

As explained above, the disc 135 may be pushed onto the end of the tobacco rod and glued to the inside circumferential face of the combining paper. For instance, either by compressing the tobacco as it is pushed or by being pushed into a part-processed consumable 102 including a recessed end as described herein. Likewise, the advantageous simultaneous pushing on the packer also applies.

Alternatively, the disc 132 can be glued to the end face 114 of the tobacco rod. Here, to avoid blocking the voids in the end face of the tobacco rod (see figure 4), the glue is applied to only a portion of the end face. For instance, the glue can be sprayed with a droplet pattern. Or the glue can be brushed, or scraped, or otherwise applied to only adhere to the fibres of the tobacco and not to fill the voids. The disc 135 can then be pushed onto the end and adhered thereto. This may be in addition to or alternative to the gluing to the inside circumferential face, and if it is not glued to the circumferential edge, the disc may not be pushed into the combining paper. However, it is envisaged that pushing into the combining paper would be beneficial to assist in alignment and to restrict the risk of the disc protruding past the outside profile of the combining paper. Moreover, in some embodiments, the disc 135 is optional and the presence of the cured liquid adhesive is sufficient to bond the fibres together and reduce the risk of fibres or particles from falling from the consumable.

In embodiments wherein the membrane 130 comprises a disc 135, the disc can be a filter such as a monoacetate filter or a bore filter or the like. Suitably here, the consumable is configured for use with a heated tobacco device, wherein the device is configured not to directly heat the disc 135. In these exemplary embodiments, the device comprises a cavity for receiving the consumable. The consumable is inserted with the disc 135 first and in either an upstream to downstream direction or in the downstream to upstream direction. The disc is pushed against a stop in the cavity. For instance, the stop may be a bottom of the cavity or maybe a ledge or the like against which the disc is pushed. Consequently, the stop acts a register point within the cavity to determine where end of the consumable is. Here, the cavity includes a heater element, having a heating zone. That is a zone in which heat is transferred to the consumable. Since the stop provides a register to determine where the disc is located, the heating zone is configured to not heat the end of the cavity in which the disc is located.

The heated tobacco consumable shown in Figure 6 is particularly advantageous for use with a device having an infrared heater disposed at the end of the cavity that receives the consumable. Infrared heaters are known. However, when used at an end of the cavity and in conjunction with a metal membrane (i.e., a foil or metal disc), it has been found that the heat can be better controlled, and a better heating is applied to the tobacco rod than without the metal membrane arranged on the end face of the tobacco rod.

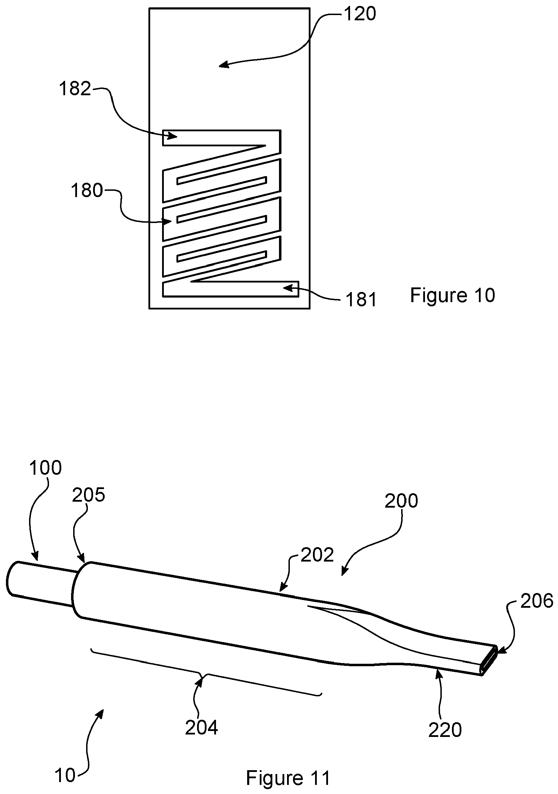

Referring to Figures 7 to 10, a further exemplary consumable is shown. The consumable 100 includes a tobacco rod 110 at one end. The tobacco rod 110 is circumscribed by combining paper 120. Sandwiched between the tobacco rod and combining paper is a resistive track 180. The resistive track is arranged between a first electrical contact 181 and a second electrical contact 182. The resistive track is configured to provide a thin and long connection between the two electrical contacts. For instance, the resistive track may wind in a spiral about the tobacco rod. However, as shown in Figure 10, the resistive track and contacts are preferably applied to the combining paper 120 before a tobacco rod 110 is placed on top and the combining paper wrapped to circumscribe the tobacco rod. Here, the resistive track can be printed or otherwise deposited, or the resistive track may be formed as a separate layer that is placed on the combining paper 120. Because the resistive track is then wrapped around the tobacco rod with the combining paper, the resistive track may wind in a back-and-forth pattern (shown as a zig zag) about the radial direction. Or the back-and-forth pattern may extend in the longitudinal direction (not shown). In either case a similar spiral winding is formed.

Here, with some of the heater circuit being distributed on the consumable, it is necessary to make an electrical connection between the consumable and the device. It is envisaged the device comprises electrical contacts such as sprung pins that are urged into contact with the electrical contacts on the consumable. As explained above, the device may include a stop at the bottom of the cavity against which the consumable is abutted. The stop acts as a register to longitudinally position the consumable in the cavity. It will be appreciated that the longitudinal alignment ensures the electrical contacts on the device and consumable are aligned.

With the contacts 181, 182 being applied to the inside of the combining paper, in the exemplary embodiment and as shown in Figure 8, the electrical contacts are exposed through the combining paper. Suitably, the electrical contacts are exposed by mechanically removing portions of the combining paper 120. For instance, by laser ablation or mechanically scraping the combining paper. Figure 7 shows the consumable prior to mechanically removing the combining paper. As shown, suitably the contacts are formed and exposed to create contact bands. The bands are shown as being spaced in the longitudinal direction. And it will be appreciated that the electrical contacts may be anode and cathode contacts. Only the electrical contacts are exposed, and the remainder of the resistive track is left unexposed and therefore protected / insulated by the combining paper.

The consumables herein described are suitable for use with a device having a cavity wherein the consumable is inserted in a downstream to upstream direction. Here, the consumables typically include cooling segments and a mouthpiece arranged sequentially downstream of the tobacco rod 110. However, the features are also applicable to a device described below, wherein the device has a cavity and the consumable is inserted into the cavity in an upstream to downstream direction. Here, the consumable does not require a mouthpiece as the user puffs on a mouthpiece provided on the device. The skilled reader will understand the modifications that can be made. Moreover, because a mouthed filter is not required, it is possible to provide symmetry to either side of the tobacco rod. For instance, both ends may be closed by folding or by a membrane or by a disc as herein described. By providing end-to-end symmetry, the consumable can be inserted in either direction without affecting performance.

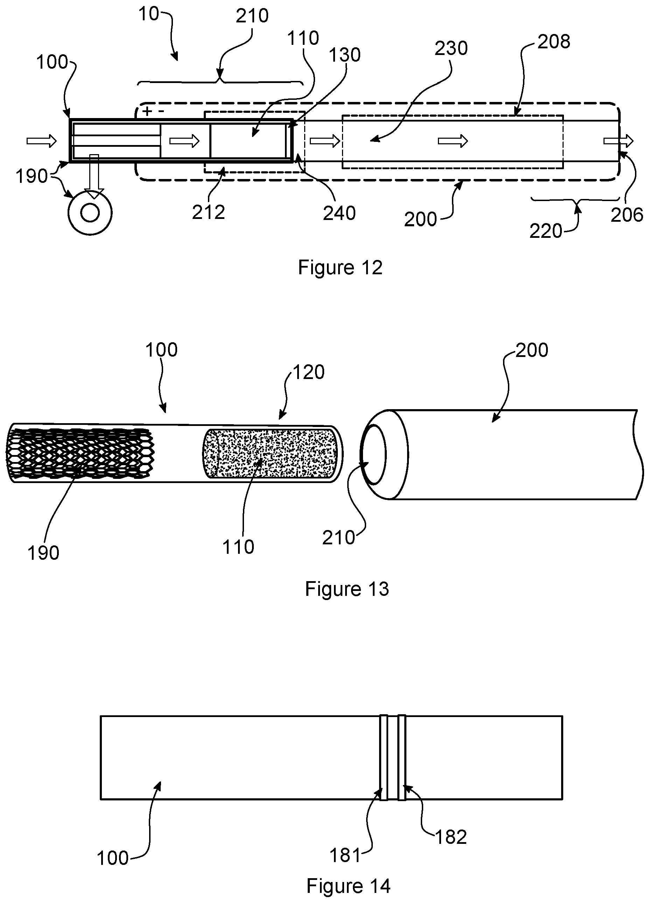

Referring to Figure 11, an exemplary heated tobacco system 10 is shown. The system 10 comprises a consumable 100 and device 200. The device 200 is an electrical device for heating the consumable 100. For instance, in general, the device 200 includes a housing or body 202 that comprises a cavity 210 for receiving the consumable, a compartment for electronics and a mouthpiece 220. In contrast to known devices where the consumable is inserted into the consumable in a downstream to upstream direction (i.e., against the airflow), the consumable 100 is inserted into the device in an upstream to downstream direction (i.e., with the airflow). Thus, the mouthpiece is provided on the device 200. The body therefor also defines an airflow passage 230 (see figure 12) between the cavity 210 and the mouthpiece 220.

The device 200 is generally elongate and provided with a cylindrical main body portion 204 that extends from an upstream end 205 and along a central axis. The cylindrical main body is intended to be held in a similar manner to a combustible cigarette. The mouthpiece 220 is shown as an integral part of the body 202 and extends between the cylindrical main body portion 204 and a downstream end 206 of the device. The external surfaces of the mouthpiece 220 are shaped top provide a comfortable mouthpiece for a user to puff on. For instance, the mouthpiece is reduced in size to the main body portion and flattened to a non-circular cross section. The mouthpiece provides an outlet 222 of the airflow passage 230.

The body 202 of the device 200 may include a user interface button and / or means for user feedback such as an LED to provide the user with a status of the device (i.e., on or level of charge etc). However, as explained, the embodiment shown in Figures 12 and 13 includes a stick recognition that can automatically turn on the heater to start the smoking session by insertion of the consumable 100. This reduces the electronics held in the compartment and allows a slimer or smaller compartment and device 200.

The cavity 210 is shown in Figure 13 as a generally cylindrical bore that extends from the downstream end of the housing 202. The cylindrical bore of the cavity 210 is generally sized to snugly fit the consumable 100. That is to have a similar diameter to the diameter of the consumable. However, the size must allow the insertion of the consumable and so further means may be provided to grip the consumable to prevent it falling out as, in use, due to the upstream to downstream insertion and that the user holds the device 200, it is likely gravity will act to withdraw the consumable 100 from the device 200. The further means may be a mechanically activated gripper or a closable lid. However, preferably it is envisaged that compressible elements in the cavity will be used. For instance, one or more o-rings (not shown) arranged to protrude into the cavity would compress against the consumable as it is inserted and act to grip the consumable 100 to the device 200.

As will be appreciated, the cavity is arranged to be coincident with the central axis of the cylindrical main body portion 204. The central bore of the cavity 210 extends along the central axis and a distance to at least accommodate the aerosol-generating substrate 110 (i.e. tobacco rod) of the consumable 100. As is known in the art, the system includes a heater and a battery to power the heater. A heating element of the heater can be any known heating element, such as resistive heater elements that penetrate the consumable for inside-out heating or that surround the cavity for outside-in heating, or an electromagnetic generator for use with a susceptor on the consumable for induction heat generation. But in Figure 12, the heating element is shown as suitably an infrared element. As is known, the infrared element emits infrared radiation across a gap or space (or as is the case through a transmissive material that forms the cavity). Thus, at least a portion of a wall of the cavity 210 is shown as an infrared heating tube 212.

As shown in Figure 12, the airflow passage 230 is provided through the device 200 from the cavity to the exit 206 on the mouthpiece. Although the airflow passage can be arranged to communicate with side walls of the cavity (dependent on where the airflow is intended to be drawn out of the consumable and in particular the tobacco rod 110), it is shown as communicating with the axial end of the cavity 210. Here, the airflow passage is coincident with the central axis of the device 200. The airflow passage 230 extends in a substantial straight line from the cavity to the mouthpiece. The airflow passage 230 is therefore a central airflow passage. However, one of the advantages of the cavity being formed at the upstream end with a mouthpiece on the device at the downstream end is that the device provides the downstream airflow passage 230 from the tobacco rod 110. Thus, it is envisaged that the airflow passage 230 may include baffles or provision for flavour introduction (such as a cavity for insertion of flavour capsules or the like in the airflow passage), or airflow sensors or the like for conditioning and cooling the generated aerosol prior to inhalation through the mouthpiece 220.

The body 202 can define air inlets to the passageway 230 and cavity 210. But otherwise, the airflow passage 230 is substantially sealed. For instance, an inlet may be provided to introduce cooling air into the airflow passage 230 downstream of the cavity and / or an inlet may be provided to the cavity upstream of where the tobacco rod 110 is intended to be positioned for introducing air into the consumable if air is not configured to be drawn through the upstream end of the consumable.

The electronics compartment is located within the body 202 and around the cavity and airflow passage 230. In figure 12, it is shown as a compartment 208 located around the airflow passage. That is, the airflow passage 230 passes through the compartment 208. The compartment 208 is shown as housing a PCBA, but in optional embodiments can include the battery of the heater circuit.

The device 200 includes a stop 240 within the cavity 210. The stop provides a register point by providing an abutment against which the consumable is pushed to prevent further insertion of the consumable into the cavity. That is, where other parts or elements of the device need to be longitudinally aligned to the inserted consumable, they can be spaced a predetermined distance from the stop corresponding to the distance the cooperating feature or element on the consumable is spaced from the distal end. The stop 240 can be a closed end of the cavity. Or the stop can be provided as a ledge that protrudes into the cavity. In either case, as explained above, an inlet to the airflow passage 230 is provided in the stop and preferably centrally. The inlet can be covered with a mesh that acts as a filter to prevent tobacco particles or fibres from entering the airflow passage. The mesh may be provided instead of or in addition to a closed end on the consumable. Though the closed end of the consumable may be sufficient on its own. Preventing tobacco particles or fibres entering the airflow passage is particularly important with an upstream cavity embodiment, because the airflow acts to pull or entice the particles into the airflow passage.

It will be appreciated that the stop or consumable may be substantially as herein described including a combination of features. For instance, the consumable is shown with a distal membrane 130 in Figure 12.

Figure 13 shows an exemplary consumable 100 for use with the device 200. Here, the consumable 100 comprises an aerosol-generating substate 110 (i.e., tobacco rod) circumscribed in wrapping paper 120. As will be appreciated, the tobacco rod is arranged at a downstream end of the consumable. A membrane 130 closes the downstream distal end of the consumable and covers the end face of the tobacco rod. Advantageously, the closed end of the consumable acts to prevent tobacco particles from passing but allows airflow. Upstream of the tobacco rod 110 is a spacing tube. In the exemplary embodiment shown in Figure 13, the upstream end of the consumable comprises a cellulose paper battery. The cellulose paper battery 190 is combined in the consumable, for instance by combining or tipping paper. The cellulose paper battery 190 can be wound in a spiral to provide airflow from the upstream end and axially to the spacing tube and for onward inhalation thorough the tobacco rod 110 and to the mouthpiece 220.

Consequently, with the provision of the battery on the consumable, a heater circuit of the system is distributed across the device 200 and consumable 100. Electrical contacts are therefore provided on the consumable and device to cooperate when inserted to allow an electrical connection. With the battery distributed on the consumable (and it is envisaged that other parts of the heater circuit such as the heating element and / or electrical connections can additionally or alternatively be distributed on the consumable), the heating circuit is not complete until the consumable is inserted into the cavity. Thus, the distribution of the heating circuit on the consumable allows for stick recognition. That is, whilst sensors or the like can be included to recognise the insertion of the consumable into the cavity, the completion of the heater circuit connecting the heating element and the battery can be used to recognise insertion of the consumable and act to automatically start the heating cycle (i.e., smoking session) for a predetermined time.

As shown in Figure 14, the electrical contacts 181, 182 on the consumable may be exposed contact bands. Two contact bands are shown corresponding to an anode and cathode connection. The electrical contacts on the device may be corresponding bands or elements such as sprung or biased pins or the like.

The features disclosed in the foregoing description, or in the following claims, or in the accompanying drawings, expressed in their specific forms or in terms of a means for performing the disclosed function, or a method or process for obtaining the disclosed results, as appropriate, may, separately, or in any combination of such features, be utilised for realising the invention in diverse forms thereof.

While the invention has been described in conjunction with the exemplary embodiments described above, many equivalent modifications and variations will be apparent to those skilled in the art when given this disclosure. Accordingly, the exemplary embodiments of the invention set forth above are considered to be illustrative and not limiting. Various changes to the described embodiments may be made without departing from the spirit and scope of the invention.

For the avoidance of any doubt, any theoretical explanations provided herein are provided for the purposes of improving the understanding of a reader. The inventors do not wish to be bound by any of these theoretical explanations.

Any section headings used herein are for organizational purposes only and are not to be construed as limiting the subject matter described.

Throughout this specification, including the claims which follow, unless the context requires otherwise, the words "have", "comprise", and "include", and variations such as "having", "comprises", "comprising", and "including" will be understood to imply the inclusion of a stated integer or step or group of integers or steps but not the exclusion of any other integer or step or group of integers or steps.

It must be noted that, as used in the specification and the appended claims, the singular forms "a," "an," and "the" include plural referents unless the context clearly dictates otherwise. Ranges may be expressed herein as from "about" one particular value, and/or to "about" another particular value. When such a range is expressed, another embodiment includes from the one particular value and/or to the other particular value. Similarly, when values are expressed as approximations, by the use of the antecedent "about," it will be understood that the particular value forms another embodiment. The term "about" in relation to a numerical value is optional and means, for example, +/- 10%.

The words "preferred" and "preferably" are used herein refer to embodiments of the invention that may provide certain benefits under some circumstances. It is to be appreciated, however, that other embodiments may also be preferred under the same or different circumstances. The recitation of one or more preferred embodiments therefore does not mean or imply that other embodiments are not useful, and is not intended to exclude other embodiments from the scope of the disclosure, or from the scope of the claims.

## Claims

1. A heated tobacco consumable comprising an aerosol-generating substrate wrapped in a wrapping substrate, wherein an electrically conductive track is arranged between the aerosol-generating substrate and the combining paper, and electrical contacts of the electrically conductive track are exposed through the combining paper.

2. The consumable of Claim 1, wherein first and second electrical contacts are exposed through the wrapping substrate, wherein the first and second contacts are spaced by a length of wrapping substrate.

3. The consumable of any of Claims 1 or 2, wherein each electrical contact comprises a contact band that substantially circumscribes the consumable.

4. The consumable of any of Claims 1 to 3, wherein the electrically conductive track comprises a component of a heating circuit, wherein the heating circuit comprises components including a battery, a heating element, electrical connections to connect the battery with the heating element, and said electrical contacts, wherein the heating circuit is suitable for heating the aerosol-generating substrate when power is supplied from the battery to the heating element.

5. The consumable of Claim 4, wherein the electrically conductive track is a heating element, wherein the electrically conductive track is a resistive track.

6. The consumable of Claim 5, wherein the electrically conductive track extends between first and second contacts.

7. The consumable of any of Claims 1 to 6, wherein the aerosol-generating substrate is elongate with first and second end faces at respective upstream and downstream ends, wherein both first and second end faces are closed ends.

8. The consumable of any of Claims 5 to 6, wherein a disc closes one or both end faces of the aerosol-generating substrate, and wherein the conductive track does not extend around the disc.

9. A heated tobacco system comprising a heater circuit, a heated tobacco consumable and a heated tobacco device, wherein:
the heater circuit comprises a battery, a heating element, electrical connections to connect the battery with the heating element, and a plurality of electrical contacts;
the consumable is as claimed in any of Claims 1 to 9, wherein said electrical contacts are one of said plurality of electrical contacts of the heater circuit; and
the device comprises a cavity for receiving the consumable, the cavity including at least one of the plurality of electrical contacts; and wherein
when the consumable is inserted into the cavity, the electrical contacts on the device and consumable make an electrical connection.

10. The system of Claim 9, wherein the system is configured to automatically begin a heating cycle by supplying power from the battery to the heating element when the electrical connections are made by insertion of the consumable into the cavity.

11. The system of any of Claims 9 or 10, wherein the device comprises a stop in the cavity, wherein the stop provides an abutment against which the consumable is pushed when the consumable is fully inserted and wherein each electrical contact of the device is spaced a predetermined distance from the stop based on a spacing of a cooperating electrical contact on the consumable from a distal end of the consumable.

12. The system of any of Claims 9 to 11, wherein:
the cavity is configured for insertion of the consumable in a downstream to upstream direction; or
the device comprises a mouthpiece at a downstream end of the device, wherein the cavity is located at an opposed upstream end of the device, wherein the device defines an air passageway between the cavity and mouthpiece and the consumable is inserted into the cavity in an upstream to downstream direction.

13. A method of manufacturing a heated tobacco consumable, the method comprises the steps of:
providing a wrapping substrate;
arranging an electrically conductive track on the wrapping substrate;
arranging an aerosol-generating substrate on the electrically conductive track;
wrapping the wrapping substrate and electrically conductive track around the aerosol-generating substrate; and
exposing electrical contacts of the electrically conductive track through the wrapping substrate.

14. The method of Claim 13, wherein the step of exposing the electrical contacts comprises removing a portion of the wrapping substrate.

15. The method of any of Claims 13 to 14, wherein the method comprises forming the consumable of any of Claims 1 to 8
